# EUROPEAN PATENT APPLICATION

(11) **EP 2 413 380 A1**
(43) Date of publication of application: **01.02.2012**
(21) Application number: 10755883.5
(22) Date of filing: 11.03.2010
(51) Int. Cl.: H01L 31/042

(54) **BACK ELECTRODE TYPE SOLAR CELL, WIRING SHEET, SOLAR CELL PROVIDED WITH WIRING SHEET, SOLAR CELL MODULE, METHOD FOR MANUFACTURING SOLAR CELL PROVIDED WITH WIRING SHEET, AND METHOD FOR MANUFACTURING SOLAR CELL MODULE**

(30) Priority: 25.03.2009 JP 2009073659
(71) Applicant: Sharp Kabushiki Kaisha, Osaka-shi, Osaka 545-8522 (JP)
(72) Inventor: ABIKO, Yoshiya, Osaka-shi, Osaka 545-8522 (JP)
(74) Representative: Hoffmann, Jörg Peter
(86) International application number: PCT/JP2010/054123
(87) International publication number: WO 2010/110083

(57) **Abstract**

Provided is a back electrode type solar cell (8) in which at least one of the first conductivity type electrode (6) and the second conductivity type electrode (7) is provided with a shape through which a liquid material can flow; a connecting sheet (10) in which at least one of the first conductivity type wire (12) and the second conductivity type wire (13) is provided with a shape through which a liquid material can flow; a solar cell with a connecting sheet using the above-described back electrode type solar cell (8) and/or the connecting sheet (10); a solar cell module; a method of manufacturing the solar cell with a connecting sheet; and a method of manufacturing the solar cell module.

## Description

### TECHNICAL FIELD

The present invention relates to a back electrode type solar cell, a connecting sheet, a solar cell with a connecting sheet, a solar cell module, a method of manufacturing a solar cell with a connecting sheet, and a method of manufacturing a solar cell module.

### BACKGROUND ART

In recent years, particularly for the purpose of protecting the global environment, expectations are dramatically growing for a solar cell as a next-generation energy source for converting solar energy into electrical energy. There are various types of solar cells such as a solar cell using a compound semiconductor, a solar cell using an organic material, and the like. The solar cell using a silicon crystal is now widely used.

A double-sided electrode type solar cell, which is most frequently manufactured and marketed in recent years, has a configuration in which an n electrode is formed on the surface on which the solar light is incident (light receiving surface) while a p electrode is formed on the surface on the side opposite to the light receiving surface (back surface).

Furthermore, for example, Japanese Patent Laying-Open No. 2005-310830 (Patent Literature 1) discloses a back electrode type solar cell having no electrode formed on its light receiving surface but having an n electrode and a p electrode formed only on its back surface.

The back electrode type solar cell having the configuration as disclosed in the above-described Patent Literature 1 is limited in electrical energy by itself that can be used. Accordingly, studies have been conducted for the method of electrically connecting a plurality of back electrode type solar cells each having the above-described configuration to form a solar cell module.

Furthermore, US Patent No. 5,951,786 (Patent Literature 2) discloses that a back electrode type solar cell is connected to a sheet having wires formed thereon to constitute a solar cell module. Patent Literature 2 also discloses that studies have been conducted with regard to the connection techniques employing solder, resistance welding, silver-containing conductive epoxy, copper foil covered by a pressure-sensitive or thermosetting conductive resin, a silver-containing adhesive, a carbon-containing adhesive, an adhesive containing gold or other conductive metal.

### CITATION LIST

### PATENT LITERATURE

PTL 1: Japanese Patent Laying-Open No. 2005-310830
PTL 2: US Patent No. 5,951,786

### SUMMARY OF INVENTION

### TECHNICAL PROBLEM

However, the studies about the connection between the electrode of the back type solar cell and the wires formed on the sheet-shaped member have been conventionally insufficient. Thus, it is desired to improve the module characteristics by improving the connection between the electrode and the wire.

In view of the above-described circumstances, an object of the present invention is to provide a back electrode type solar cell, a connecting sheet, a solar cell with a connecting sheet, a solar cell module, a method of manufacturing the solar cell with a connecting sheet, and a method of manufacturing the solar cell module, which allow an improvement in the characteristics of the solar cell module.

### SOLUTION TO PROBLEM

The present invention provides a back electrode type solar cell including a semiconductor substrate in which a first conductivity type impurity diffusion region and a second conductivity type impurity diffusion region are formed; and a first conductivity type electrode and a second conductivity type electrode formed on one of surfaces of the semiconductor substrate and corresponding to the first conductivity type impurity diffusion region and the second conductivity type impurity diffusion region, respectively. At least one of the first conductivity type electrode and the second conductivity type electrode protrudes in a direction opposite to the semiconductor substrate so as to have a width continuously reduced in accordance with an increase in a distance from the semiconductor substrate.

Furthermore, the present invention provides a solar cell with a connecting sheet. The solar cell with a connecting sheet includes the back electrode type solar cell; and a connecting sheet having an insulating base material, and a first conductivity type wire and a second conductivity type wire disposed on the insulating base material. The back electrode type solar cell is disposed on the connecting sheet such that the first conductivity type electrode of the back electrode type solar cell is in contact with the first conductivity type wire of the connecting sheet and the second conductivity type electrode of the back electrode type solar cell is in contact with the second conductivity type wire of the connecting sheet. An insulating resin joins at least a part of a region between the back electrode type solar cell and the connecting sheet excluding a region in which the first conductivity type electrode of the back electrode type solar cell is in contact with the first conductivity type wire of the connecting sheet to establish electrical connection therebetween, and a region in which the second conductivity type electrode of the back electrode type solar cell is in contact with the second conductivity type wire of the connecting sheet to establish electrical connection therebetween. Furthermore, the present invention provides a solar cell module in which the above-described solar cell with a connecting sheet is sealed by a sealing material on a transparent substrate.

Furthermore, the present invention provides a back electrode type solar cell including a semiconductor substrate in which a first conductivity type impurity diffusion region and a second conductivity type impurity diffusion region are formed; and a first conductivity type electrode and a second conductivity type electrode formed on one of surfaces of the semiconductor substrate and corresponding to the first conductivity type impurity diffusion region and the second conductivity type impurity diffusion region, respectively. At least one of the first conductivity type electrode and the second conductivity type electrode has a surface provided with a plurality of convex portions and a concave portion formed between the convex portions and located contiguous to an end.

Furthermore, the present invention provides a solar cell with a connecting sheet. The solar cell with a connecting sheet includes the above-described back electrode type solar cell; and a connecting sheet having an insulating base material, and a first conductivity type wire and a second conductivity type wire disposed on the insulating base material. The back electrode type solar cell is disposed on the connecting sheet such that the first conductivity type electrode of the back electrode type solar cell is in contact with the first conductivity type wire of the connecting sheet and the second conductivity type electrode of the back electrode type solar cell is in contact with the second conductivity type wire of the connecting sheet. An insulating resin joins at least a part of a region between the back electrode type solar cell and the connecting sheet excluding a region in which the first conductivity type electrode of the back electrode type solar cell is in contact with the first conductivity type wire of the connecting sheet to establish electrical connection therebetween and a region in which the second conductivity type electrode of the back electrode type solar cell is in contact with the second conductivity type wire of the connecting sheet to establish electrical connection therebetween. Furthermore, the present invention provides a solar cell module in which the above-described solar cell with a connecting sheet is sealed by a sealing material on a transparent substrate.

Furthermore, the present invention provides a connecting sheet including an insulating base material; and a first conductivity type wire and a second conductivity type wire disposed on the insulating base material in order to connect an electrode of a back electrode type solar cell. At least one of the first conductivity type wire and the second conductivity type wire protrudes in a direction opposite to the insulating base material so as to have a width continuously reduced in accordance with an increase in a distance from the insulating base material.

Furthermore, the present invention provides a solar cell with a connecting sheet. The solar cell with a connecting sheet includes the above-described connecting sheet; and a back electrode type solar cell having a first conductivity type electrode and a second conductivity type electrode formed on one of surfaces of a semiconductor substrate having a first conductivity type impurity diffusion region and a second conductivity type impurity diffusion region formed therein, in which the first conductivity type electrode and the second conductivity type electrode correspond to the first conductivity type impurity diffusion region and the second conductivity type impurity diffusion region, respectively. The back electrode type solar cell is disposed on the connecting sheet such that the first conductivity type electrode of the back electrode type solar cell is in contact with the first conductivity type wire of the connecting sheet and the second conductivity type electrode of the back electrode type solar cell is in contact with the second conductivity type wire of the connecting sheet. An insulating resin joins at least a part of a region between the back electrode type solar cell and the connecting sheet excluding a region in which the first conductivity type electrode of the back electrode type solar cell is in contact with the first conductivity type wire of the connecting sheet to establish electrical connection therebetween, and a region in which the second conductivity type electrode of the back electrode type solar cell is in contact with the second conductivity type wire of the connecting sheet to establish electrical connection therebetween. Furthermore, the present invention provides a solar cell module in which the above-described solar cell with a connecting sheet is sealed by a sealing material on a transparent substrate.

Furthermore, the present invention provides a connecting sheet including an insulating base material; and a first conductivity type wire and a second conductivity type wire disposed on the insulating base material in order to connect an electrode of a back electrode type solar cell. At least one of the first conductivity type wire and the second conductivity type wire has a surface provided with a plurality of convex portions and a concave portion formed between the convex portions and located contiguous to an end.

Furthermore, the present invention provides a solar cell with a connecting sheet. The solar cell with a connecting sheet includes the above-described connecting sheet; and a back electrode type solar cell having a first conductivity type electrode and a second conductivity type electrode formed on one of surfaces of a semiconductor substrate having a first conductivity type impurity diffusion region and a second conductivity type impurity diffusion region formed therein, in which the first conductivity type electrode and the second conductivity type electrode correspond to the first conductivity type impurity diffusion region and the second conductivity type impurity diffusion region, respectively. The back electrode type solar cell is disposed on the connecting sheet such that the first conductivity type electrode of the back electrode type solar cell is in contact with the first conductivity type wire of the connecting sheet and the second conductivity type electrode of the back electrode type solar cell is in contact with the second conductivity type wire of the connecting sheet. An insulating resin joins at least a part of a region between the back electrode type solar cell and the connecting sheet excluding a region in which the first conductivity type electrode of the back electrode type solar cell is in contact with the first conductivity type wire of the connecting sheet to establish electrical connection therebetween, and a region in which the second conductivity type electrode of the back electrode type solar cell is in contact with the second conductivity type wire of the connecting sheet to establish electrical connection therebetween. Furthermore, the present invention provides a solar cell module in which the above-described solar cell with a connecting sheet is sealed by a sealing material on a transparent substrate.

Furthermore, the present invention provides a method of manufacturing a solar cell with a connecting sheet. The solar cell with a connecting sheet includes a back electrode type solar cell having a first conductivity type electrode and a second conductivity type electrode formed on one of surfaces of a semiconductor substrate having a first conductivity type impurity diffusion region and a second conductivity type impurity diffusion region formed therein, in which the first conductivity type electrode and the second conductivity type electrode correspond to the first conductivity type impurity diffusion region and the second conductivity type impurity diffusion region, respectively; and a connecting sheet having an insulating base material, and a first conductivity type wire and a second conductivity type wire disposed on the insulating base material. The method includes the steps of: applying an insulating resin on a surface of the connecting sheet including a surface of the first conductivity type wire and/or a surface of the second conductivity type wire; and placing the back electrode type solar cell on the connecting sheet.

Furthermore, the present invention provides a method of manufacturing a solar cell module. The method includes the step of sealing the solar cell with a connecting sheet manufactured by the above-described method of manufacturing the solar cell with a connecting sheet on a transparent substrate by a sealing material.

Furthermore, the present invention provides a method of manufacturing a solar cell with a connecting sheet. The solar cell with a connecting sheet includes a back electrode type solar cell having a first conductivity type electrode and a second conductivity type electrode formed on one of surfaces of a semiconductor substrate having a first conductivity type impurity diffusion region and a second conductivity type impurity diffusion region formed therein, in which the first conductivity type electrode and the second conductivity type electrode correspond to the first conductivity type impurity diffusion region and the second conductivity type impurity diffusion region, respectively; and a connecting sheet having an insulating base material, and a first conductivity type wire and a second conductivity type wire disposed on the insulating base material. The method includes the steps of: applying an insulating resin on a surface of the back electrode type solar cell including a surface of the first conductivity type wire and/or a surface of the second conductivity type wire; and placing the back electrode type solar cell on the connecting sheet.

Furthermore, the present invention provides a method of manufacturing a solar cell module. The method includes the step of sealing the solar cell with a connecting sheet manufactured by the above-described method of manufacturing the solar cell with a connecting sheet on a transparent substrate by a sealing material.

### ADVANTAGEOUS EFFECTS OF INVENTION

According to the present invention, a back electrode type solar cell, a connecting sheet, a solar cell with a connecting sheet, a solar cell module, a method of manufacturing the solar cell with a connecting sheet, and a method of manufacturing the solar cell module can be provided which allow an improvement in the characteristics of the solar cell module.

### BRIEF DESCRIPTION OF DRAWINGS

Fig. 1 is a schematic cross sectional view of an example of a solar cell module according to the present invention.
Fig. 2 is a schematic enlarged cross sectional view of the solar cell module shown in Fig. 1 taken along the II-II direction.
Figs. 3(a) to (g) each are a schematic cross sectional view illustrating an example of a method of manufacturing a back electrode type solar cell shown in Figs. 1 and 2.
Fig. 4 is a schematic plan view of an example of the back surface of the back electrode type solar cell used in the present invention.
Figs. 5(a) to (d) each are a schematic cross sectional view illustrating an example of a method of manufacturing a connecting sheet shown in Figs. 1 and 2.
Fig. 6 is a schematic plan view of an example of a surface of the connecting sheet used in the present invention.
Figs. 7(a) to (c) each are a schematic cross sectional view illustrating an example of a method of manufacturing a solar cell with a connecting sheet shown in Figs. 1 and 2.
Fig. 8 is a schematic cross sectional view of another example of the solar cell module according to the present invention.
Fig. 9 is a schematic cross sectional view of another example of the solar cell module according to the present invention.
Fig. 10 is a schematic cross sectional view of another example of the solar cell module according to the present invention.
Fig. 11 is a schematic enlarged cross sectional view of the solar cell module shown in Fig. 10 taken along the XI-XI direction.
Figs. 12(a) to (c) each are a schematic cross sectional view illustrating an example of a method of manufacturing a back electrode type solar cell shown in Figs. 10 and 11.
Fig. 13 is a schematic enlarged cross sectional view of another example of the solar cell module according to the present invention.
Fig. 14 is a schematic enlarged cross sectional view of another example of the solar cell module according to the present invention.
Fig. 15 is a schematic cross sectional view of another example of the solar cell module according to the present invention.
Fig. 16 is a schematic enlarged cross sectional view of the solar cell module shown in Fig. 15 taken along the XVI-XVI direction.
Figs. 17(a) to (c) each are a schematic cross sectional view illustrating an example of a method of manufacturing the solar cell with a connecting sheet shown in Fig. 15.
Fig. 18 is a schematic enlarged cross sectional view of another example of the solar cell module according to the present invention.
Fig. 19 is a schematic enlarged cross sectional view of another example of the solar cell module according to the present invention.
Fig. 20 is an EL (Electro Luminescence) luminescence image of a solar cell module of an example.
Fig. 21 is an EL luminescence image of a solar cell module of a comparative example.

### DESCRIPTION OF EMBODIMENTS

The embodiments of the present invention will be hereinafter described. In the accompanying drawings of the present invention, the same or corresponding components are designated by the same reference characters.

### [First embodiment]

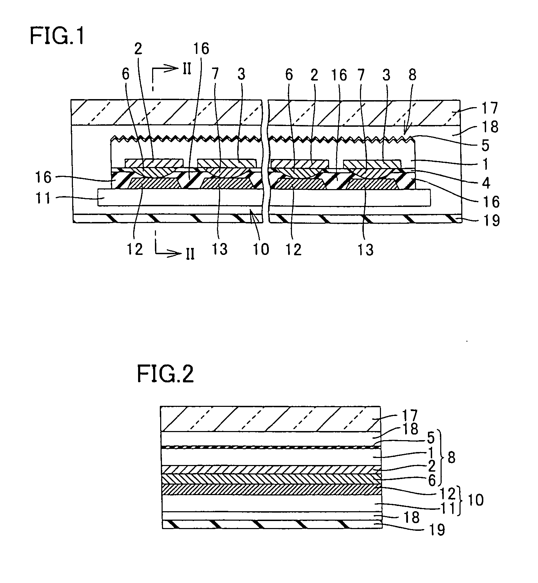

Fig. 1 shows a schematic cross sectional view of an example of a solar cell module according to the present invention. The solar cell module having a configuration shown in Fig. 1 is configured such that a solar cell with a connecting sheet configured to have a back electrode type solar cell 8 disposed on a connecting sheet 10 is sealed in a sealing material 18 such as ethylene vinyl acetate between a transparent substrate 17 such as a glass substrate and a back film 19 such as a polyester film.

In this case, a semiconductor substrate 1 of back electrode type solar cell 8 has a light receiving surface on which a concavo-convex structure such as a textured structure is formed. An antireflection film 5 is formed so as to cover the concavo-convex structure. Furthermore, a passivation film 4 is formed on the back surface of semiconductor substrate 1 of back electrode type solar cell 8.

Furthermore, back electrode type solar cell 8 includes semiconductor substrate 1; a first conductivity type impurity diffusion region 2 and a second conductivity type impurity diffusion region 3 formed on the back surface of semiconductor substrate 1; a first conductivity type electrode 6 formed to be in contact with first conductivity type impurity diffusion region 2; and a second conductivity type electrode 7 formed to be in contact with second conductivity type impurity diffusion region 3. Therefore, first conductivity type electrode 6 corresponding to first conductivity type impurity diffusion region 2 and second conductivity type electrode 7 corresponding to second conductivity type impurity diffusion region 3 are formed on the back surface of semiconductor substrate 1.

In this case, first conductivity type electrode 6 and second conductivity type electrode 7 on the back surface of back electrode type solar cell 8 are shaped to protrude in the direction opposite to semiconductor substrate 1. The electrode width of first conductivity type electrode 6 and the electrode width of second conductivity type electrode 7 each are continuously reduced in accordance with an increase in the distance from semiconductor substrate 1. The outer surface of first conductivity type electrode 6 and the outer surface of second conductivity type electrode 7 each are a curved surface that is curved like a side surface of a circular cylinder.

In this way, first conductivity type electrode 6 and second conductivity type electrode 7 of back electrode type solar cell 8 each are configured to have the above-described shape, so that first conductivity type electrode 6 and second conductivity type electrode 7 each can be shaped to push away insulating resin 16 at the time of connection to connection sheet 10, to electrically connect to the wire of connecting sheet 10.

In other words, first conductivity type electrode 6 and second conductivity type electrode 7 of back electrode type solar cell 8 each have a shape formed thereon, through which insulating resin 16 can flow in the uncured liquid material state. This shape allows uncured insulating resin 16 to flow therethrough that is disposed between the electrode and the wire when first conductivity type electrode 6 and second conductivity type electrode 7 are brought into contact with first conductivity type wire 12 and second conductivity type wire 13, respectively, of connecting sheet 10.

In this example, first conductivity type impurity diffusion region 2 and second conductivity type impurity diffusion region 3 each are formed in the strip shape extending on the front surface side and/or the back surface side of the plane of Fig. 1. In addition, first conductivity type impurity diffusion region 2 and second conductivity type impurity diffusion region 3 are disposed on the back surface of semiconductor substrate 1 alternately at a predetermined distance from each other.

Furthermore, in this example, first conductivity type electrode 6 and second conductivity type electrode 7 each are also formed in the strip shape extending on the front surface side and/or the back surface side of the plane of Fig. 1. In addition, first conductivity type electrode 6 and second conductivity type electrode 7 are formed to be brought into contact with first conductivity type impurity diffusion region 2 and second conductivity type impurity diffusion region 3, respectively, through openings provided in passivation film 4 along first conductivity type impurity diffusion region 2 and second conductivity type impurity diffusion region 3, respectively, on the back surface of semiconductor substrate 1.

Furthermore, connecting sheet 10 includes an insulating base material 11; and a first conductivity type wire 12 and a second conductivity type wire 13 each formed in a predetermined shape on the surface of insulating base material 11.

Furthermore, first conductivity type wire 12 on insulating base material 11 of connecting sheet 10 is formed to face a corresponding one of first conductivity type electrodes 6 on the back surface of back electrode type solar cell 8.

Furthermore, second conductivity type wire 13 on insulating base material 11 of connecting sheet 10 is formed to face a corresponding one of second conductivity type electrodes 7 on the back surface of back electrode type solar cell 8.

In this example, first conductivity type wire 12 and second conductivity type wire 13 of connecting sheet 10 are also formed in the strip shape extending on the front surface side and/or the back surface side of the plane of Fig. 1.

In addition, the above-described back electrode type solar cell 8 and the above-described connecting sheet 10 are joined by insulating resin 16 that is an electrical insulating resin provided between back electrode type solar cell 8 and connecting sheet 10.

Fig. 2 shows a schematic enlarged cross sectional view of the solar cell module shown in Fig. 1 taken along the II-II direction (the extension direction of each of first conductivity type electrode 6 of back electrode type solar cell 8 and first conductivity type wire 12 of connecting sheet 10: the direction extending on the front surface side and/or the back surface side of the plane of Fig. 1).

In this case, as shown in Fig. 2, first conductivity type electrode 6 of back electrode type solar cell 8 is electrically connected to first conductivity type wire 12 of connecting sheet 10 continuously along the extension direction of each of first conductivity type electrode 6 of back electrode type solar cell 8 and first conductivity type wire 12 of connecting sheet 10.

Although not shown, second conductivity type electrode 7 of back electrode type solar cell 8 is also electrically connected to second conductivity type wire 13 of connecting sheet 10 continuously along the extension direction of each of second conductivity type electrode 7 of back electrode type solar cell 8 and second conductivity type wire 13 of connecting sheet 10, as in the case of first conductivity type electrode 6 shown in Fig. 2.

Furthermore, for the sake of explanation, the concavo-convex structure on the light receiving surface of semiconductor substrate 1 is not shown as a concavo-convex shape in Fig. 2.

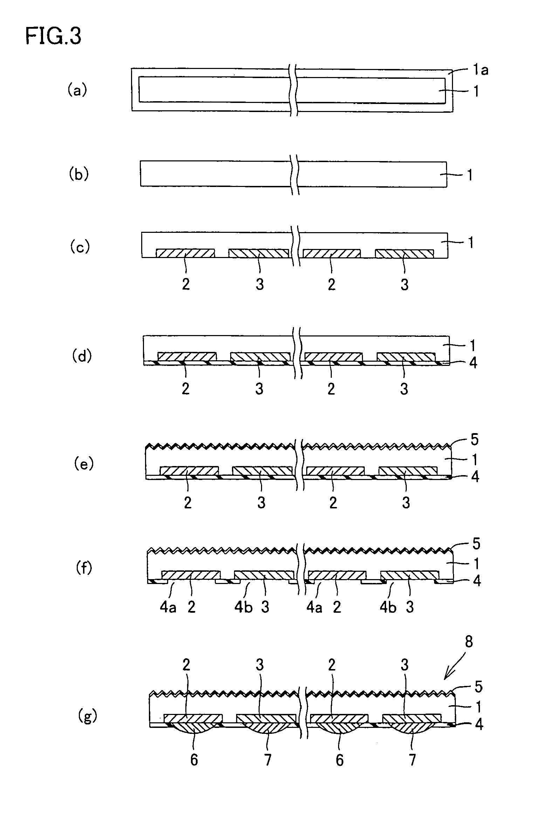

An example of the method of manufacturing back electrode type solar cell 8 shown in Figs. 1 and 2 will be hereinafter described with reference to the schematic cross sectional view in each of Figs. 3(a) to 3(g).

First, as shown in Fig. 3(a), semiconductor substrate 1 having slice damage 1a formed on the surface thereof is prepared, for example, by slicing from an ingot, and the like. In this case, an example of semiconductor substrate 1 may include a silicon substrate made of monocrystalline silicon or polycrystalline silicon having n-type conductivity or p-type conductivity.

Then, as shown in Fig. 3(b), slice damage 1a on the surface of semiconductor substrate 1 is removed. For example, in the case where semiconductor substrate 1 is made of the silicon substrate as described above, slice damage 1a can be removed by etching the surface of the above-described sliced silicon substrate by mixed acid of hydrogen fluoride aqueous solution and nitric acid, by alkaline aqueous solution such as sodium hydroxide, or the like.

In this case, although the size and the shape of semiconductor substrate 1 obtained after removal of slice damage 1a are not particularly limited, it is preferable that semiconductor substrate 1 can be configured to have a thickness of, for example, 100 µm or more and 500 µm or less, and particularly, about 200 µm.

Then, as shown in Fig. 3(c), first conductivity type impurity diffusion region 2 and second conductivity type impurity diffusion region 3 are formed on the back surface of semiconductor substrate 1. In this case, first conductivity type impurity diffusion region 2 can be formed, for example, by the method such as vapor-phase diffusion using gas containing first conductivity type impurities while second conductivity type impurity diffusion region 3 can be formed, for example, by the method such as vapor-phase diffusion using gas containing second conductivity type impurities.

In this case, first conductivity type impurity diffusion region 2 is not particularly limited as long as it contains first conductivity type impurities and has n-type conductivity or p-type conductivity. As to the first conductivity type impurity, for example, an n-type impurity such as phosphorus can be used when the first conductivity type is an n-type, and, for example, a p-type impurity such as boron or aluminum can be used when the first conductivity type is a p-type.

Furthermore, second conductivity type impurity diffusion region 3 is not particularly limited as long as it contains second conductivity type impurities and has conductivity opposite to that of first conductivity type impurity diffusion region 2. As to the second conductivity type impurity, for example, an n-type impurity such as phosphorus can be used when the second conductivity type is an n-type, and, for example, a p-type impurity such as boron or aluminum can be used when the second conductivity type is a p-type.

In addition, the first conductivity type may be n-type conductivity or p-type conductivity while the second conductivity type only needs to have conductivity opposite to that of the first conductivity type. In other words, when the first conductivity type has n-type conductivity, the second conductivity type has p-type conductivity, and when the first conductivity type has p-type conductivity, the second conductivity type has n-type conductivity.

As to the gas containing the first conductivity type impurities, for example, the gas containing n-type impurities such as phosphorus like POCl₃ can be used when the first conductivity type is an n-type, while, for example, the gas containing p-type impurities such as boron like BBr₃ can be used when the first conductivity type is a p-type.

As to the gas containing the second conductivity type impurities, for example, the gas containing n-type impurities such as phosphorus like POCl₃ can be used when the second conductivity type is an n-type, while, for example, the gas containing p-type impurities such as boron like BBr₃ can be used when the second conductivity type is a p-type.

Then, as shown in Fig. 3(d), passivation film 4 is formed on the back surface of semiconductor substrate 1. In this case, passivation film 4 can be formed by the method such as a thermal oxidation method or a plasma CVD (Chemical Vapor Deposition) method, for example.

In this case, although examples of passivation film 4 may include a silicon oxide film, a silicon nitride film, or a layered body made of a silicon oxide film and a silicon nitride film, passivation film 4 is not limited thereto.

Furthermore, passivation film 4 can be configured to have a thickness, for example, of 0.05 µm or more and 1 µm or less, and particularly preferably, approximately 0.2 µm.

Then, as shown in Fig. 3(e), after the concavo-convex structure such as a textured structure is formed on the entire light receiving surface of semiconductor substrate 1, antireflection film 5 is formed on the concavo-convex structure.

In this case, the textured structure can be formed, for example, by etching the light receiving surface of semiconductor substrate 1. For example, in the case where semiconductor substrate 1 is a silicon substrate, the textured structure can be formed by etching the light receiving surface of semiconductor substrate 1, using the etching solution obtained by adding isopropyl alcohol to the alkaline aqueous solutions such as sodium hydroxide or potassium hydroxide and then heating the resultant solution, for example, to 70 °C or higher and 80 °C or lower.

Furthermore, antireflection film 5 can be formed, for example, by the plasma CVD method and the like. Although, for example, a silicon nitride film and the like can be used as antireflection film 5, antireflection film 5 is not limited thereto.

Then, as shown in Fig. 3(f), a contact hole 4a and a contact hole 4b are formed by removing a part of passivation film 4 on the back surface of semiconductor substrate 1. In this case, contact hole 4 is formed by exposing at least a part of the surface of first conductivity type impurity diffusion region 2 while contact hole 4b is formed by exposing at least a part of the surface of second conductivity type impurity diffusion region 3.

It is to be noted that contact hole 4a and contact hole 4b each can be formed, for example, by the method using a photolithography technique such as a method of forming, on passivation film 4, a resist pattern having an opening in a portion corresponding to the area where each of contact holes 4a and 4b are formed, and then, removing passivation film 4 from the opening of the resist pattern by etching and the like, or a method of applying etching paste to a portion of passivation film 4 corresponding to the area where each of contact holes 4a and 4b are formed, which is followed by heating to etch and remove passivation film 4.

Then, as shown in Fig. 3(g), back electrode type solar cell 8 is produced by forming first conductivity type electrode 6 that is in contact with first conductivity type impurity diffusion region 2 through contact hole 4a and second conductivity type electrode 7 that is in contact with second conductivity type impurity diffusion region 3 through contact hole 4b.

In this case, first conductivity type electrode 6 and second conductivity type electrode 7 can be shaped to push away insulating resin 16 at the time of connection to the above-described connecting sheet 10 and electrically connect to the wire of connecting sheet 10, for example, by the screen printing method, the vacuum deposition method, the plating method or the like.

For example, in the case where first conductivity type electrode 6 and second conductivity type electrode 7 are formed by the screen printing method, a screen made using emulsion agent such as emulsion and formed to have an opening patterned in accordance with the electrode pattern is used, or a metal screen having a thin metal plate provided with an opening patterned in accordance with the electrode pattern is used, to gradually extrude the metal paste having a certain degree of viscosity through the opening of the screen toward semiconductor substrate 1 by the pressure applied from the screen. In this case, the metal paste adhering to semiconductor substrate 1 receives the force spreading in the lateral direction by the reaction force from semiconductor substrate 1. This allows formation of inclinations in such a manner that the metal paste has a width that is greater in the vicinity of semiconductor substrate 1 than the width of the screen opening and becomes approximately equal to the width of the screen opening in accordance with an increase in the distance from semiconductor substrate 1. Then, the metal paste is dried, for example, at a temperature of approximately 50 °C to 200 °C, and then, baked at a temperature of approximately 300 °C to 800 °C, to thereby form first conductivity type electrode 6 and second conductivity type electrode 7.

Furthermore, in the case where first conductivity type electrode 6 and second conductivity type electrode 7 are formed by the vacuum deposition method, the metal is subjected to vacuum deposition on the back surface side of semiconductor substrate 1 in the state where there is a distance between semiconductor substrate 1 and the metal mask having an opening patterned in the electrode pattern, or in the state where the cross section of the opening of the metal mask is inclined. This allows first conductivity type electrode 6 and second conductivity type electrode 7 to be formed in the above-described shapes, respectively. Furthermore, in the case where first conductivity type electrode 6 and second conductivity type electrode 7 each are formed from metal that can be etched, the surface of each of these electrodes is processed for a short period of time, for example, by wet etching using dilute acid or alkalis. Consequently, the edge portion of the electrode having high surface energy is preferentially etched, so that the end of the electrode can be rounded off.

Furthermore, in the case where first conductivity type electrode 6 and second conductivity type electrode 7 are formed by the plating method, the resist for the photolithography process or the resist for screen printing is patterned on the back surface of semiconductor substrate 1 so as to provide an opening patterned in the electrode pattern, which is followed by heat treatment of the resist, thereby providing an inclination on the cross section of the opening of the resist. Then, semiconductor substrate 1 is immersed in the plating bath, to cause a plated layer to be deposited through the opening of the resist. Consequently, first conductivity type electrode 6 and second conductivity type electrode 7 each made of the plated layer can be formed.

Furthermore, after the resist is patterned and the plating seed layer as a plating start layer is formed in the opening of the above-described resist by the RF sputtering method and the like, the resist is removed to cause a plated layer to be deposited on the plating seed layer. Consequently, first conductivity type electrode 6 and second conductivity type electrode 7 each made of the plated layer can also be formed. In this case, the plated layer is deposited spontaneously in a semicircular shape such that the surface energy is constant. Accordingly, first conductivity type electrode 6 and second conductivity type electrode 7 each having a shape as described above can be formed.

In addition, for example, an electrode made of metal such as silver can be used as first conductivity type electrode 6 and second conductivity type electrode 7.

Furthermore, in order to suitably push away insulating resin 16 to improve the stability of the connection between the electrode of back electrode type solar cell 8 and the wire of connecting sheet 10, it is preferable that first conductivity type electrode 6 and second conductivity type electrode 7 each are configured to have a thickness of 10 nm or more and 1000 µm or less.

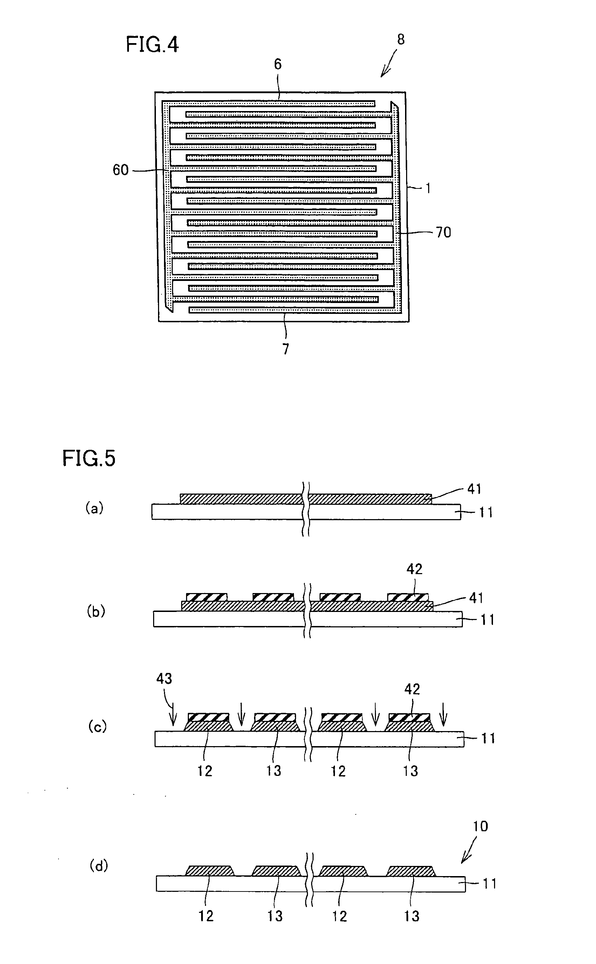

Fig. 4 shows a schematic plan view of an example of the back surface of back electrode type solar cell 8 produced as described above. In this case, first conductivity type electrode 6 and second conductivity type electrode 7 each are formed in the strip shape on the back surface of back electrode type solar cell 8. Then, a plurality of strip-shaped first conductivity type electrodes 6 are connected to one strip-shaped first conductivity type collector electrode 60 while a plurality of strip-shaped second conductivity type electrodes 7 are connected to one strip-shaped second conductivity type collector electrode 70. In this example, first conductivity type collector electrode 60 is formed to extend in the direction vertical to the longitudinal direction of strip-shaped first conductivity type electrode 6 while second conductivity type collector electrode 70 is formed to extend in the direction vertical to the longitudinal direction of strip-shaped second conductivity type electrode 7.

Therefore, on the back surface of back electrode type solar cell 8 having the configuration shown in Fig. 4, one first conductivity type collector electrode 60 and the plurality of first conductivity type electrodes 6 constitute one comb-shaped electrode while one second conductivity type collector electrode 70 and the plurality of second conductivity type electrodes 7 constitute one comb-shaped electrode. In addition, first conductivity type electrode 6 and second conductivity type electrode 7 corresponding to comb-teeth of the comb-shaped electrode are arranged to face each other such that the comb-teeth are engaged one by one with each other. Furthermore, one strip-shaped first conductivity type impurity diffusion region 2 is disposed on the back surface portion of semiconductor substrate 1 that is in contact with strip-shaped first conductivity type electrode 6 while one strip-shaped second conductivity type impurity diffusion region 3 is disposed on the back surface portion of semiconductor substrate 1 that is in contact with strip-shaped second conductivity type electrode 7.

An example of the method of manufacturing connecting sheet 10 shown in Figs. 1 and 2 will be hereinafter described with reference to the schematic cross sectional view in each of Figs. 5(a) to 5(d).

First, as shown in Fig. 5(a), a conductive layer 41 is formed on the surface of insulating base material 11. In this case, although examples of insulating base material 11 may include a substrate made of resin such as polyester, polyethylene naphthalate or polyimide, insulating base material 11 is not limited thereto.

Furthermore, it is preferable that insulating base material 11 has a thickness of, for example, 10 µm or more and 200 µm or less, and particularly, approximately 25 µm.

Furthermore, examples of conductive layer 41 may include a layer made of metal such as copper, but conductive layer 41 is not limited thereto.

Then, as shown in Fig. 5(b), a resist 42 is formed on conductive layer 41 on the surface of insulating base material 11. In this case, resist 42 is formed to have an opening in the area other than the area where first conductivity type wire 12 and second conductivity type wire 13 are formed. For example, conventionally known materials can be used as resist 42, and, for example, may include a material obtained by curing the resin that has been applied to the predetermined position by the method such as screen printing, dispenser application, ink jet application or the like.

Then, as shown in Fig. 5(c), a part of conductive layer 41 exposed from resist 42 is removed in the direction indicated by an arrow 43, thereby patterning conductive layer 41, to form first conductivity type wire 12 and second conductivity type wire 13 from the remainder of conductive layer 41.

In this case, conductive layer 41 can be removed, for example, by wet etching and the like using an acid solution or an alkaline solution.

Then, as shown in Fig. 5(d), connecting sheet 10 is fabricated by removing entire resist 42 from the surface of first conductivity type wire 12 and the surface of second conductivity type wire 13.

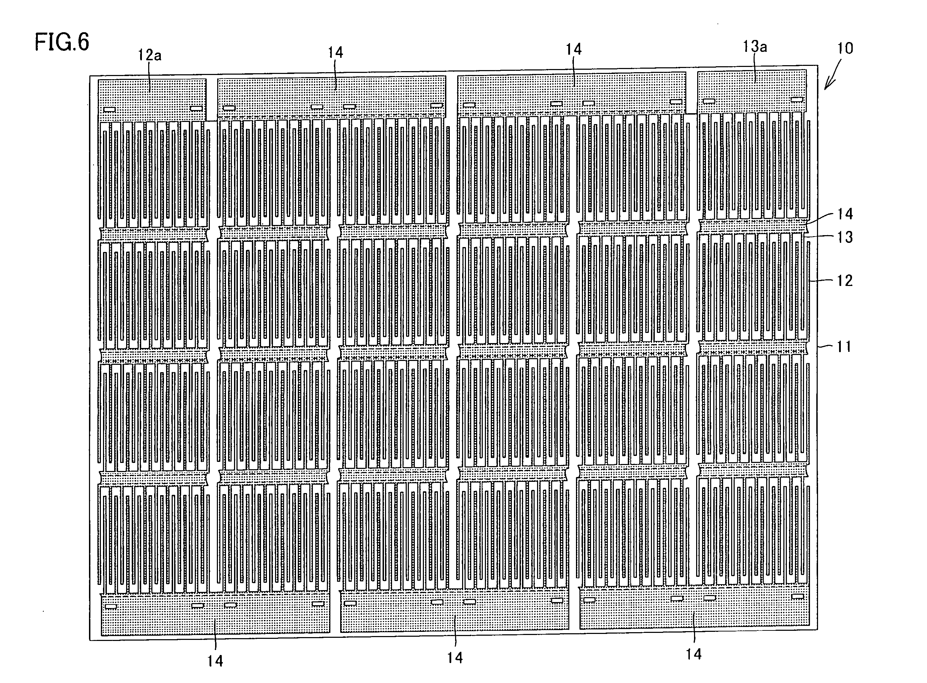

Fig. 6 shows a schematic plan view of an example of the surface of connecting sheet 10 fabricated as described above. In this case, first conductivity type wire 12 and second conductivity type wire 13 each are formed in the strip shape on the surface of insulating base material 11 of connecting sheet 10. In addition, on the surface of insulating base material 11 of connecting sheet 10, a connecting wire 14 having a strip shape is formed which electrically connects first conductivity type wire 12 and second conductivity type wire 13. It is to be noted that connecting wire 14 can be formed, for example, from the remainder of conductive layer 41 as in the case of first conductivity type wire 12 and second conductivity type wire 13.

According to the configuration as described above, first conductivity type wire 12 and second conductivity type wire 13 adjacent to each other excluding a comb-shaped first conductivity type wire 12a and a comb-shaped second conductivity type wire 13a each located at the end of connecting sheet 10 are electrically connected to each other by connecting wire 14. This causes electrical connection to be established between the back electrode type solar cells located adjacent to each other on connecting sheet 10. Therefore, all of the back electrode type solar cells disposed on connecting sheet 10 may be electrically connected in series.

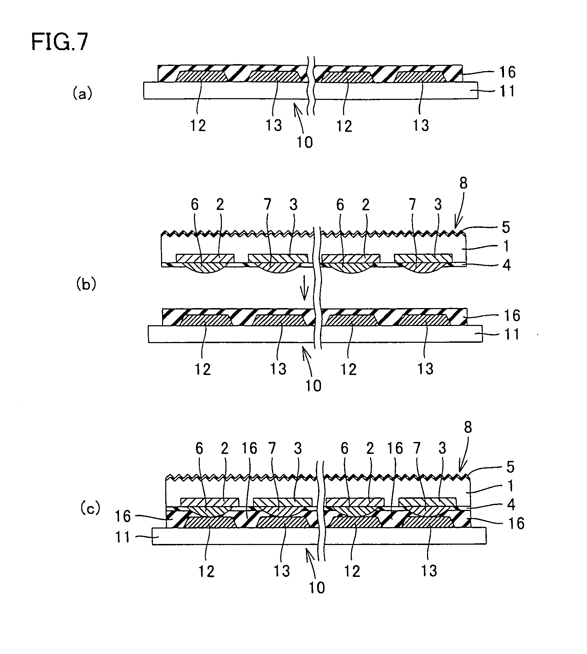

An example of the method of manufacturing the solar cell with a connecting sheet shown in Figs. 1 and 2 will be hereinafter described with reference to the schematic cross sectional view in Figs. 7(a) to 7(c).

First, as shown in Fig. 7(a), insulating resin 16 is applied on the surface of connecting sheet 10 fabricated as described above. In the case where insulating resin 16 is applied on the surface of connecting sheet 10, insulating resin 16 can be applied, for example, on the surface of connecting sheet 10 including the surface of first conductivity type wire 12 and/or the surface of second conductivity type wire 13 in connecting sheet 10. In this case, insulating resin 16 can be applied, for example, by the method such as screen printing, dispenser application or ink jet application. Furthermore, the resin having electrical insulation properties can be used as insulating resin 16 without any limitation. For example, thermosetting resin, light curing resin or the like that are conventionally known can also be used. It is to be noted that insulating resin 16 may be applied on the surface of back electrode type solar cell 8. In the case where insulating resin 16 is applied on the surface of back electrode type solar cell 8, for example, insulating resin 16 can be applied on the surface of back electrode type solar cell 8 including the surface of first conductivity type electrode 6 and/or the surface of second conductivity type electrode 7 in back electrode type solar cell 8.

Then, as shown in Fig. 7(b), back electrode type solar cell 8 is disposed on connecting sheet 10.

In this case, as shown in Fig. 7(c), back electrode type solar cell 8 is disposed on connecting sheet 10 such that first conductivity type electrode 6 of back electrode type solar cell 8 is disposed on first conductivity type wire 12 of connecting sheet 10 while second conductivity type electrode 7 of back electrode type solar cell 8 is disposed on second conductivity type wire 13 of connecting sheet 10. This establishes connection between back electrode type solar cell 8 and connecting sheet 10.

In this case, first conductivity type electrode 6 and second conductivity type electrode 7 of back electrode type solar cell 8 each are shaped to push away insulating resin 16 to establish electrical connection to the wire of connecting sheet 10, as described above. Accordingly, insulating resin 16 located below each of first conductivity type electrode 6 and second conductivity type electrode 7 and also located between back electrode type solar cell 8 and connecting sheet 10. is pushed away to the outside of the end portion of each of first conductivity type electrode 6 and second conductivity type electrode 7. In other words, uncured insulating resin 16 in the liquid material state flows between first conductivity type electrode 6 and first conductivity type wire 12 and between second conductivity type electrode 7 and second conductivity type wire 13, so that first conductivity type electrode 6 is in contact with first conductivity type wire 12 while second conductivity type electrode 7 is in contact with second conductivity type wire 13.

Accordingly, the end portion of first conductivity type electrode 6 is brought into contact with first conductivity type wire 12 to thereby ensure electrical connection therebetween while the end portion of second conductivity type electrode 7 is also brought into contact with second conductivity type wire 13 of connecting sheet 10, to thereby ensure electrical connection therebetween.

Therefore, in the case where back electrode type solar cell 8 having the above-described configuration is used, it becomes possible to suppress the problem that insulating resin 16 is sandwiched between the electrode of back electrode type solar cell 8 and the wire of connecting sheet 10, to prevent electrical connection from being established between the electrode of back electrode type solar cell 8 and the wire of connecting sheet 10. Accordingly, the characteristics of the solar cell with a connecting sheet and the solar cell module described below can be improved.

Then, upon heating of insulating resin 16 applied as described above and/or light irradiation onto insulating resin 16 applied as described above, insulating resin 16 is cured, with the result that back electrode type solar cell 8 and connecting sheet 10 are joined to each other by cured insulating resin 16. Then, first conductivity type electrode 6 and second conductivity type electrode 7 of back electrode type solar cell 8 are partially joined by insulating resin 16 to first conductivity type wire 12 and second conductivity type wire 13, respectively, of connecting sheet 10. Also, in the area other than this joined portion, first conductivity type electrode 6 and second conductivity type electrode 7 of back electrode type solar cell 8 are in contact with first conductivity type wire 12 and second conductivity type wire 13, respectively, of connecting sheet 10, so that electrical connection is established therebetween.

Then, for example, as shown in Fig. 1, the solar cell with a connecting sheet obtained after insulating resin 16 cures is sandwiched between transparent substrate 17 such as a glass substrate provided with sealing material 18 such as ethylene vinyl acetate and back film 19 such as a polyester film provided with sealing material 18, to seal back electrode type solar cell 8 constituting a solar cell with a connecting sheet within sealing material 18. Consequently, a solar cell module is produced. It is to be noted that insulating resin 16 may be cured when back electrode type solar cell 8 constituting a solar cell with a connecting sheet is sealed within sealing material 18.

Furthermore, in the above-described configuration, first conductivity type electrode 6 and second conductivity type electrode 7 of back electrode type solar cell 8 each are shaped to push away insulating resin 16 to establish electrical connection to the wire of connecting sheet 10. In the present invention, however, at least one of first conductivity type electrode 6 and second conductivity type electrode 7 only needs to be shaped to push away insulating resin 16 to establish electrical connection to the wire of connecting sheet 10. In other words, at least one of first conductivity type electrode 6 and second conductivity type electrode 7 only needs to have a shape through which insulating resin 16 can flow in the uncured liquid material state.

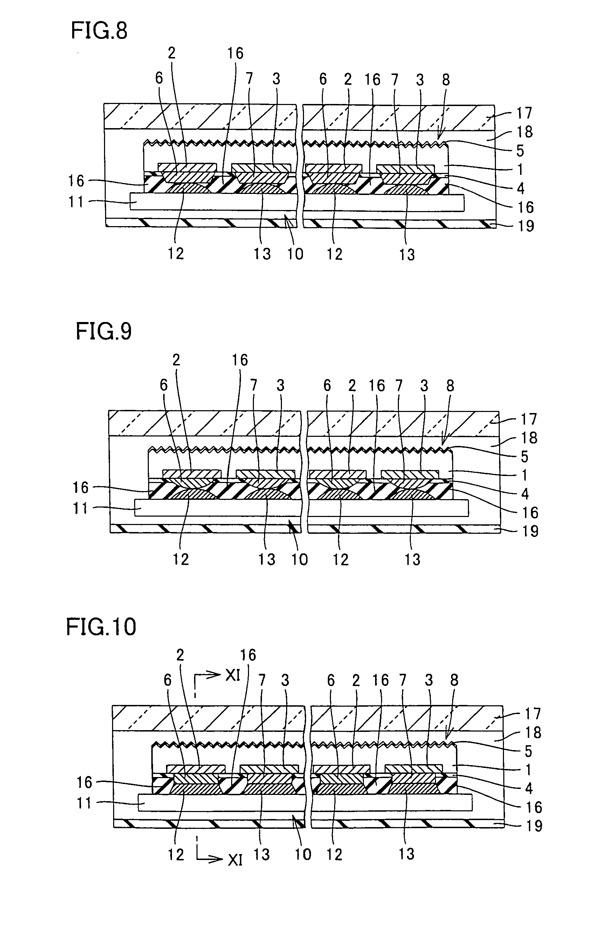

Furthermore, in the above-described configuration, first conductivity type electrode 6 and second conductivity type electrode 7 of back electrode type solar cell 8 each are shaped to push away insulating resin 16 to establish electrical connection to the wire of connecting sheet 10. In the present invention, however, for example, as shown in the schematic cross sectional view in Fig. 8, each of first conductivity type wire 12 and second conductivity type wire 13 on the surface of insulating base material 11 of connecting sheet 10 may be shaped to push away insulating resin 16 at the time of connection to back electrode type solar cell 8 to establish electrical connection to the electrode of back electrode type solar cell 8. In other words, first conductivity type wire 12 and second conductivity type wire 13 of connecting sheet 10 may have a shape through which insulating resin 16 can flow in the uncured liquid material state. The above-described shape allows uncured insulating resin 16 to flow therethrough that is disposed between the electrode and the wire when first conductivity type electrode 6 and second conductivity type electrode 7 of back electrode type solar cell 8 are brought into contact with first conductivity type wire 12 and second conductivity type wire 13, respectively, of connecting sheet 10.

In this case, first conductivity type wire 12 and second conductivity type wire 13 on the surface of insulating base material 11 of connecting sheet 10 each are formed to protrude in the direction opposite to insulating base material 11. In addition, the electrode width of first conductivity type wire 12 and the electrode width of second conductivity type wire 13 each are continuously reduced in accordance with an increase in the distance from insulating base material 11. The outer surface of first conductivity type wire 12 and the outer surface of second conductivity type wire 13 each are a curved surface that is curved like a side surface of a circular cylinder.

Furthermore, as to the method of forming the shape of each of first conductivity type wire 12 and second conductivity type wire 13 of connecting sheet 10 so as to push away insulating resin 16 at the time of connection to back electrode type solar cell 8 to thereby establish electrical connection to the electrode of back electrode type solar cell 8, for example, these wires can be formed by the above-mentioned screen printing method, vacuum deposition method, plating method or the like, but may also be formed by etching a metal foil.

In this case, in the case where first conductivity type wire 12 and second conductivity type wire 13 of connecting sheet 10 are formed by etching a metal foil, first, the metal foil formed by rolling, an electrolytic plating method and the like is formed on the surface of insulating base material 11. Then, after a resist is patterned on the surface of the metal foil, the metal foil is etched by acid and the like, thereby patterning the metal foil in the pattern of each of first conductivity type wire 12 and second conductivity type wire 13. Then, the surface of each of first conductivity type wire 12 and second conductivity type wire 13 made of the patterned metal foils are processed for a short period of time, for example, by wet etching using dilute acid and an alkaline solution, which causes the edge portion of the wire having high surface energy to be preferentially etched. Consequently, the surface of first conductivity type wire 12 and the surface of second conductivity type wire 13 can be rounded off.

Furthermore, in the configuration shown in Fig. 8, every wire of first conductivity type wire 12 and second conductivity type wire 13 in connecting sheet 10 is shaped to push away insulating resin 16 to establish electrical connection to the electrode of back electrode type solar cell 8. In contrast, in the present invention, at least one wire of first conductivity type wire 12 and second conductivity type wire 13 only needs to be shaped to push away insulating resin 16 to thereby establish electrical connection to the electrode of back electrode type solar cell 8. In other words, at least one of first conductivity type wire 12 and second conductivity type wire 13 only needs to have a shape through which insulating resin 16 can flow in the uncured liquid material state.

In the configuration shown in Fig. 8, in order to suitably push away insulating resin 16 to improve the stability of the connection between the electrode of back electrode type solar cell 8 and the wire of connecting sheet 10, it is preferable that first conductivity type wire 12 and second conductivity type wire 13 each have a thickness of 10 nm or more and 1000 µm or less.

Furthermore, in the present invention, for example, as shown in the schematic cross sectional view in Fig. 9, first conductivity type electrode 6 and second conductivity type electrode 7 of back electrode type solar cell 8 each may be shaped to push away insulating resin 16 at the time of connection to connecting sheet 10 to thereby establish electrical connection to the wire of connecting sheet 10, while first conductivity type wire 12 and second conductivity type wire 13 on the surface of insulating base material 11 of connecting sheet 10 each may be shaped to push away insulating resin 16 at the time of connection to back electrode type solar cell 8 to thereby establish electrical connection to the electrode of back electrode type solar cell 8. In other words, first conductivity type electrode 6 and second conductivity type electrode 7 of back electrode type solar cell 8 may have a shape through which insulating resin 16 can flow in the uncured liquid material state, while first conductivity type wire 12 and second conductivity type wire 13 of connecting sheet 10 may have a shape through which insulating resin 16 can flow in the uncured liquid material state.

Also in the configuration shown in Fig. 9, it is preferable that the thickness of each of first conductivity type electrode 6, second conductivity type electrode 7, first conductivity type wire 12, and second conductivity type wire 13 for suitably pushing away insulating resin 16 to improve the stability of the connection between the electrode of back electrode type solar cell 8 and the wire of connecting sheet 10 is set to fall within the range of 10 nm or more and 1000 µm or less, as in the above-described configuration.

As described above, in the present invention, the electrode of back electrode type solar cell 8 and/or the wire of connecting sheet 10 are shaped to push away insulating resin 16, that is, the electrode of back electrode type solar cell 8 and/or the wire of connecting sheet 10 are configured to have a shape through which a liquid material can flow, which allows suppression of sandwiching of insulating resin 16, so that it becomes possible to achieve a value that is favorable as a contact resistance between the electrode of back electrode type solar cell 8 and the wire of connecting sheet 10. Accordingly, the solar cell with a connecting sheet and the solar cell module which are produced by the present invention can achieve the value that is favorable as a series resistance component among the electrical characteristics, so that F. F. (Fill Factor) during light irradiation can be improved.

It is to be noted that the concept of the back electrode type solar cell in the present invention includes not only the configuration in which both of the first conductivity type electrode and the second conductivity type electrode are formed only on one of the surfaces (back surface side) of the above-described semiconductor substrate, but also every configuration of the so-called back-contact type solar cell (a solar cell having the structure in which electric current is taken out from the back surface opposite to the light receiving surface side of the solar cell) such as an MWT (Metal Wrap Through) cell (a solar cell having the configuration in which a part of the electrode is disposed in a through hole provided in the semiconductor substrate).

Furthermore, the concept of the solar cell with a connecting sheet in the present invention includes not only the configuration in which a plurality of back electrode type solar cells are disposed on the connecting sheet, but also the configuration in which one back electrode type solar cell is disposed on the connecting sheet.

### [Second embodiment]

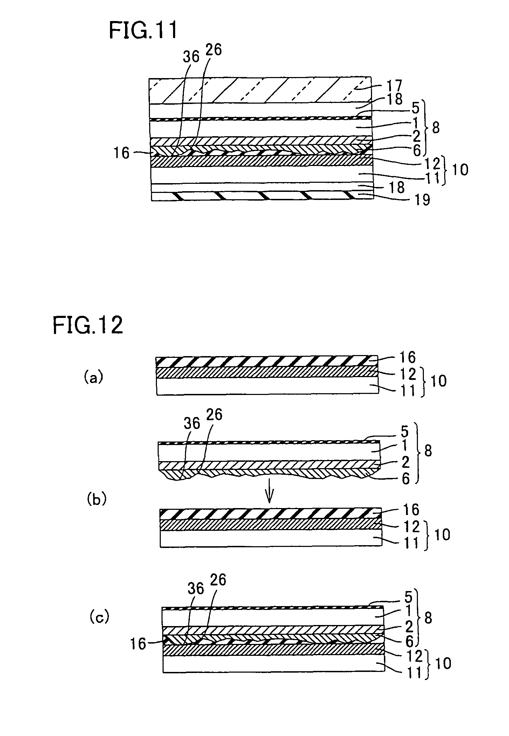

Fig. 10 shows a schematic cross sectional view of another example of the solar cell module according to the present invention. Fig. 11 shows a schematic enlarged cross sectional view of the solar cell module shown in Fig. 10 taken along the XI-XI direction (each extension direction of first conductivity type electrode 6 of back electrode type solar cell 8 and first conductivity type wire 12 of connecting sheet 10: the direction extending on the front surface side and/or the back surface side of the plane of Fig. 10).

For example, as shown in Fig. 11, the solar cell module of the present embodiment is **characterized in that** the surface of first conductivity type electrode 6 of back electrode type solar cell 8 has a concave portion 26 and a convex portion 36 along the extension direction of first conductivity type electrode 6, and concave portion 26 on the surface of first conductivity type electrode 6 is formed as a resin flowing portion for causing flow of insulating resin 16 pushed away by convex portion 36 of first conductivity type electrode 6.

Furthermore, although not shown, the surface of second conductivity type electrode 7 of back electrode type solar cell 8 also has a concave portion and a convex portion along the extension direction of second conductivity type electrode 7 as in the surface of first conductivity type electrode 6 shown in Fig. 11, and the concave portion on the surface of second conductivity type electrode 7 is also formed as a resin flowing portion for causing insulating resin 16 to flow.

In other words, in the second embodiment, first conductivity type electrode 6 and second conductivity type electrode 7 of back electrode type solar cell 8 each has a resin flowing portion that is shaped to push away insulating resin 16 at the time of connection to connecting sheet 10 to establish electrical connection to the wire of connecting sheet 10 and also serves to cause flow of insulating resin 16 that is pushed away.

In the second embodiment, first conductivity type electrode 6 and second conductivity type electrode 7 of back electrode type solar cell 8 each have concave portion 26 through which insulating resin 16 can flow in the uncured liquid material state. Such a concave portion 26 is formed as a resin flowing portion that is configured to have a shape through which uncured insulating resin 16 can flow that is disposed between the electrode and the wire when convex portion 36 of first conductivity type electrode 6 and the convex portion of second conductivity type electrode 7 are brought into contact with first conductivity type wire 12 and second conductivity type wire 13, respectively, of connecting sheet 10. In addition, this resin flowing portion also causes uncured insulating resin 16 to flow therethrough.

It is preferable that concave portion 26 of first conductivity type electrode 6 is formed between the plurality of convex portions 36 so as to be contiguous to the end of first conductivity type electrode 6. Furthermore, it is preferable that concave portion 26 of second conductivity type electrode 7 is formed between the plurality of convex portions 36 so as to be contiguous to the end of second conductivity type electrode 7. In the case where concave portion 26 of first conductivity type electrode 6 is located contiguous to the end of first conductivity type electrode 6, it is more likely that insulating resin 16 pushed away by convex portion 36 of first conductivity type electrode 6 and then flowing into concave portion 26 of first conductivity type electrode 6 can be discharged from the end of first conductivity type electrode 6 to the outside of first conductivity type electrode 6. Furthermore, in the case where concave portion 26 of second conductivity type electrode 7 is located contiguous to the end of second conductivity type electrode 7, it is more likely that insulating resin 16 pushed away by convex portion 36 of second conductivity type electrode 7 and then flowing into concave portion 26 of second conductivity type electrode 7 can be discharged from the end of second conductivity type electrode 7 to the outside of second conductivity type electrode 7. In addition, the end of first conductivity type electrode 6 may be, for example, the end in the direction orthogonal to the extension direction of first conductivity type electrode 6 while the end of second conductivity type electrode 7 may be, for example, the end in the direction orthogonal to the extension direction of second conductivity type electrode 7.

In this case, first conductivity type electrode 6 and second conductivity type electrode 7 of back electrode type solar cell 8 each having a resin flowing portion shaped as shown in Fig. 11 can be formed, for example, by the screen printing method, the vacuum deposition method, the plating method, or the like.

For example, in the case where first conductivity type electrode 6 and second conductivity type electrode 7 are formed by the screen printing method, a screen is first prepared that is provided not only with an opening of the screen corresponding to each pattern of first conductivity type electrode 6 and second conductivity type electrode 7 (hereinafter referred to as a "main opening"), but also with openings disposed at arbitrary intervals also in the direction orthogonal to the longitudinal direction of the above-mentioned opening (extension direction of the electrode) (hereinafter each referred to as a "sub opening"). Then, metal paste is gradually extruded through the screen toward semiconductor substrate 1 and then printed. In this case, in the area of the main opening in the screen provided with the sub opening, metal paste flows also into the sub opening, in which portion the printed metal paste is reduced in thickness. Accordingly, a concave portion and a convex portion can be formed along the extension direction of each surface of first conductivity type electrode 6 and second conductivity type electrode 7. Then, the metal paste is dried, for example, at a temperature of approximately 50 °C to 200 °C, and then baked at a temperature of approximately 300 °C to 800 °C, so that first conductivity type electrode 6 and second conductivity type electrode 7 can be formed.

Furthermore, in the case where first conductivity type electrode 6 and second conductivity type electrode 7 are formed by the vacuum deposition method, as described above, the metal mask having a main opening and a sub opening is used to cause the metal to be vacuum-deposited on the opening of the metal mask, so that first conductivity type electrode 6 and second conductivity type electrode 7 can be formed.

Furthermore, in the case where first conductivity type electrode 6 and second conductivity type electrode 7 are formed by the plating method, as described above, a resist is formed to have a main opening and a sub opening to deposit a plated layer on the opening of the resist, so that first conductivity type electrode 6 and second conductivity type electrode 7 each made of the plated layer can be formed.

Furthermore, in order to suitably push away insulating resin 16 to improve the stability of the connection between the electrode of back electrode type solar cell 8 and the wire of connecting sheet 10, it is preferable that first conductivity type electrode 6 and second conductivity type electrode 7 each are configured to have a thickness of 10 nm or more and 1000 µm or less.

An example of the method of manufacturing a solar cell with a connecting sheet used in the solar cell module shown in Figs. 10 and 11 will be hereinafter described with reference to the schematic enlarged cross sectional view shown in each of Figs. 12(a) to 12(c). It is to be noted that Figs. 12(a) to 12(c) each are an enlarged cross sectional view as seen from the same direction as that in Fig. 11.

First, as shown in Fig. 12(a), insulating resin 16 is applied on the surface of connecting sheet 10 fabricated as described above. In this case, insulating resin 16 will be applied also on the surface of first conductivity type wire 12 of connecting sheet 10. Furthermore, although not shown, insulating resin 16 will be applied also on the surface of second conductivity type wire 13 of connecting sheet 10. In addition, in the case where insulating resin 16 is applied on the surface of connecting sheet 10, insulating resin 16 can be applied, for example, on the surface of connecting sheet 10 including the surface of first conductivity type wire 12 and/or the surface of second conductivity type wire 13 in connecting sheet 10. Also, insulating resin 16 may be applied on the surface of back electrode type solar cell 8. In the case where insulating resin 16 is applied on the surface of back electrode type solar cell 8, insulating resin 16 can be applied, for example, on the surface of back electrode type solar cell 8 including the surface of first conductivity type electrode 6 and/or the surface of second conductivity type electrode 7 of back electrode type solar cell 8.

Then, as shown in Fig. 12(b), back electrode type solar cell 8 is disposed on connecting sheet 10.

In this case, as shown in Fig. 12(c), back electrode type solar cell 8 is disposed on connecting sheet 10 such that first conductivity type electrode 6 of back electrode type solar cell 8 is disposed on first conductivity type wire 12 of connecting sheet 10. Although not shown, second conductivity type electrode 7 of back electrode type solar cell 8 will be disposed on second conductivity type wire 13 of connecting sheet 10. This causes back electrode type solar cell 8 and connecting sheet 10 to be connected to each other.

In this case, convex portion 36 of first conductivity type electrode 6 and the convex portion (not shown) of second conductivity type electrode 7 in back electrode type solar cell 8 each will push away insulating resin 16 on connecting sheet 10. Insulating resin 16 pushed away by these convex portions of the electrodes will be placed within concave portion 26 of first conductivity type electrode 6 and the concave portion (not shown) of second conductivity type electrode 7 each serving as a resin flowing portion. In other words, uncured insulating resin 16 in the liquid material state flows between first conductivity type electrode 6 and first conductivity type wire 12 and between second conductivity type electrode 7 and second conductivity type wire 13, which causes convex portion 36 of first conductivity type electrode 6 to be brought into contact with first conductivity type wire 12 while causing the convex portion of second conductivity type electrode 7 to be brought into contact with second conductivity type wire 13. When insulating resin 16 that flows in this case is placed and cured within the resin flowing portion (concave portion 26 of first conductivity type electrode 6 and the concave portion of second conductivity type electrode 7), this insulating resin 16 joins first conductivity type electrode 6 and first conductivity type wire 12 together and also joins second conductivity type electrode 7 and second conductivity type wire 13 together in the resin flowing portion.

Therefore, convex portion 36 of first conductivity type electrode 6 is brought into contact with first conductivity type wire 12 to ensure electrical connection therebetween while the convex portion of second conductivity type electrode 7 is brought into contact with second conductivity type wire 13 of connecting sheet 10 to ensure electrical connection therebetween.

In the state where insulating resin 16 is cured, first conductivity type electrode 6 and second conductivity type electrode 7 in back electrode type solar cell 8 and first conductivity type wire 12 and second conductivity type wire 13 in connecting sheet 10 are partially joined together in the resin flowing portion by insulating resin 16 and also brought into contact with each other at the top portion of the convex portion other than the resin flowing portion, thereby establishing electrical connection therebetween.

Therefore, in the case where back electrode type solar cell 8 having the above-described configuration is used, it becomes possible to suppress the problem that insulating resin 16 is sandwiched between the electrode of back electrode type solar cell 8 and the wire of connecting sheet 10, which prevents electrical connection between the electrode of back electrode type solar cell 8 and the wire of connecting sheet 10. Therefore, the characteristics of the solar cell with a connecting sheet and the solar cell module can be improved.

Furthermore, since insulating resin 16 is filled in the resin flowing portion of the electrode of back electrode type solar cell 8 to cover and protect the periphery of the electrode, the long-term reliability of the solar cell with a connecting sheet and the solar cell module can also be enhanced.

In the above-described configuration, first conductivity type electrode 6 and second conductivity type electrode 7 of back electrode type solar cell 8 each are provided with the resin flowing portion. In the present invention, however, at least one of first conductivity type electrode 6 and second conductivity type electrode 7 only needs to be provided with the resin flowing portion.

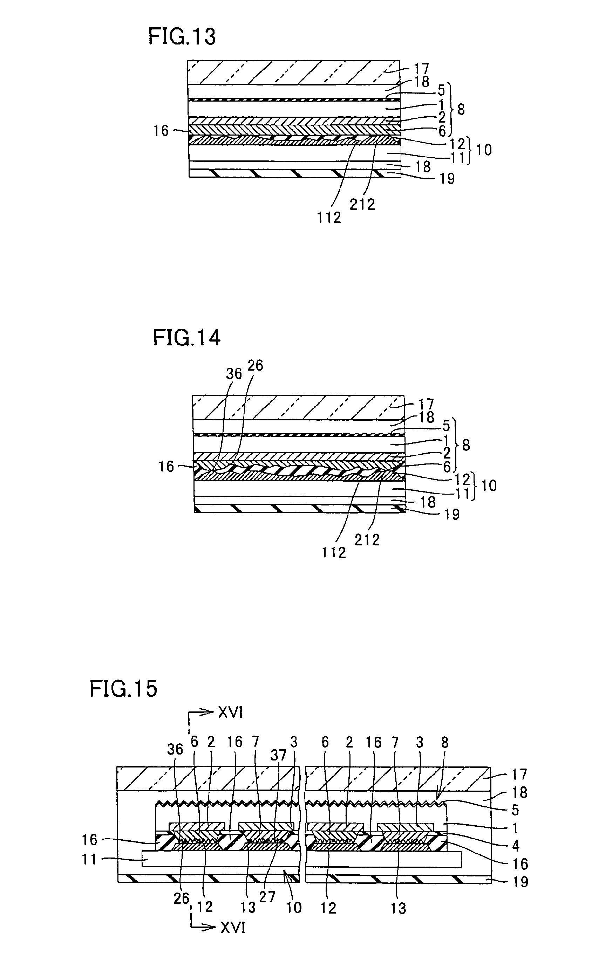

Furthermore, in the above-described configuration, concave portion 26 of first conductivity type electrode 6 and the concave portion (not shown) of second conductivity type electrode 7 in back electrode type solar cell 8 each are formed as a resin flowing portion. In the present invention, however, as shown in the schematic enlarged cross sectional view in Fig. 13, a concave portion 112 and a convex portion 212 are provided on the surface of first conductivity type wire 12 of connecting sheet 10 along the extension direction of first conductivity type wire 12, while a concave portion (not shown) and a convex portion (not shown) may be provided on the surface of second conductivity type wire 13 along the extension direction of second conductivity type wire 13. In this case, concave portion 112 in first conductivity type wire 12 and a concave portion (not shown) in second conductivity type wire 13 each serve as a resin flowing portion.

It is preferable that concave portion 112 of first conductivity type wire 12 is formed between the plurality of convex portions 212 so as to be contiguous to the end of first conductivity type wire 12. Furthermore, it is also preferable that concave portion 112 of second conductivity type wire 13 is formed between the plurality of convex portions 212 so as to be contiguous to the end of second conductivity type wire 13. In the case where concave portion 112 of first conductivity type wire 12 is located contiguous to the end of first conductivity type wire 12, it is more likely that insulating resin 16 pushed away by convex portion 212 of first conductivity type wire 12 and then flowing into concave portion 112 of first conductivity type wire 12 can be discharged from the end of first conductivity type wire 12 to the outside of first conductivity type wire 12. Furthermore, in the case where concave portion 112 of second conductivity type wire 13 is located contiguous to the end of second conductivity type wire 13, it is more likely that insulating resin 16 pushed away by convex portion 212 of second conductivity type wire 13 and then flowing into concave portion 112 of second conductivity type wire 13 can be discharged from the end of second conductivity type wire 13 to the outside of second conductivity type wire 13. It is to be noted that the end of first conductivity type wire 12 may be, for example, the end in the direction orthogonal to the extension direction of first conductivity type wire 12 and the end of second conductivity type wire 13 may be, for example, the end in the direction orthogonal to the extension direction of second conductivity type wire 13.

In this case, although first conductivity type wire 12 having concave portion 112 and convex portion 212 and second conductivity type wire 13 having a concave portion (not shown) and a convex portion (not shown) can also be formed, for example, by the above-mentioned screen printing method, the vacuum deposition method, the plating method or the like, these wires can also be formed by etching a metal foil.

In the case where first conductivity type wire 12 and second conductivity type wire 13 of connecting sheet 10 are formed by etching a metal foil, for example, the metal foil formed by rolling, the electrolytic plating method and the like is first formed on the surface of insulating base material 11. Then, in the same manner as described above, after a resist is patterned on the surface of the metal foil so as to provide a main opening and a sub opening, the metal foil is etched by acid or the like, to pattern the metal foil in the pattern of each of first conductivity type wire 12 and second conductivity type wire 13. Consequently, first conductivity type wire 12 and second conductivity type wire 13 each made of patterned metal foil can be formed.

Furthermore, in the configuration shown in Fig. 13, the resin flowing portion is provided in each of first conductivity type wire 12 and second conductivity type wire 13 in connecting sheet 10. In the present invention, however, the resin flowing portion only needs to be provided in at least one of first conductivity type wire 12 and second conductivity type wire 13. In the configuration shown in Fig. 13, in order to suitably push away insulating resin 16 to improve the stability of the connection between the electrode of back electrode type solar cell 8 and the wire of connecting sheet 10, it is preferable that first conductivity type wire 12 and second conductivity type wire 13 each have a thickness of 10 nm or more and 1000 µm or less.

Furthermore, in the present invention, for example, as shown in the schematic enlarged cross sectional view in Fig. 14, a resin flowing portion may be provided in each of first conductivity type electrode 6 and second conductivity type electrode 7 of back electrode type solar cell 8, while a resin flowing portion may also be provided in each of first conductivity type wire 12 and second conductivity type wire 13 on the surface of insulating base material 11 of connecting sheet 10. Also in the configuration shown in Fig. 14, it is preferable that the thickness of each of first conductivity type electrode 6, second conductivity type electrode 7, first conductivity type wire 12, and second conductivity type wire 13 for suitably pushing away insulating resin 16 to improve the stability of the connection between the electrode of back electrode type solar cell 8 and the wire of connecting sheet 10 is 10 nm or more and 1000 µm or less as in the above-described configuration.

In this case, it is preferable that concave portion 26 of first conductivity type electrode 6 is formed between the plurality of convex portions 36 so as to be contiguous to the end of first conductivity type electrode 6. Furthermore, it is preferable that concave portion 26 of second conductivity type electrode 7 is formed between the plurality of convex portions 36 so as to be contiguous to the end of second conductivity type electrode 7. In the case where concave portion 26 of first conductivity type electrode 6 is located contiguous to the end of first conductivity type electrode 6, it is more likely that insulating resin 16 pushed away by convex portion 36 of first conductivity type electrode 6 and then flowing into concave portion 26 of first conductivity type electrode 6 can be discharged from the end of first conductivity type electrode 6 to the outside of first conductivity type electrode 6. Also, in the case where concave portion 26 of second conductivity type electrode 7 is located contiguous to the end of second conductivity type electrode 7, it is more likely that insulating resin 16 pushed away by convex portion 36 of second conductivity type electrode 7 and then flowing into concave portion 26 of second conductivity type electrode 7 can be discharged from the end of second conductivity type electrode 7 to the outside of second conductivity type electrode 7. It is to be noted that the end of first conductivity type electrode 6 may be, for example, the end in the direction orthogonal to the extension direction of first conductivity type electrode 6 while the end of second conductivity type electrode 7 may be, for example, the end in the direction orthogonal to the extension direction of second conductivity type electrode 7.

Furthermore, it is preferable that concave portion 112 of first conductivity type wire 12 is formed between the plurality of convex portions 212 so as to be contiguous to the end of first conductivity type wire 12. Furthermore, it is preferable that concave portion 112 of second conductivity type wire 13 is formed between the plurality of convex portions 212 so as to be contiguous to the end of second conductivity type wire 13. In the case where concave portion 112 of first conductivity type wire 12 is located contiguous to the end of first conductivity type wire 12, it is more likely that insulating resin 16 pushed away by convex portion 212 of first conductivity type wire 12 and then flowing into concave portion 112 of first conductivity type wire 12 can be discharged from the end of first conductivity type wire 12 to the outside of first conductivity type wire 12. In the case where concave portion 112 of second conductivity type wire 13 is located contiguous to the end of second conductivity type wire 13, it is more likely that insulating resin 16 pushed away by convex portion 212 of second conductivity type wire 13 and then flowing into concave portion 112 of second conductivity type wire 13 can be discharged from the end of second conductivity type wire 13 to the outside of second conductivity type wire 13. It is to be noted that the end of first conductivity type wire 12 may be, for example, the end in the direction orthogonal to the extension direction of first conductivity type wire 12 while the end of second conductivity type wire 13 may be, for example, the end in the direction orthogonal to the extension direction of second conductivity type wire 13.

Furthermore, for the sake of explanation, the concavo-convex structure on the light receiving surface of semiconductor substrate 1 is not shown as a concavo-convex shape in Figs. 11 to 14.

Description other than the above in the present embodiment is the same as that in the first embodiment, and therefore, will not be repeated.

### [Third Embodiment]

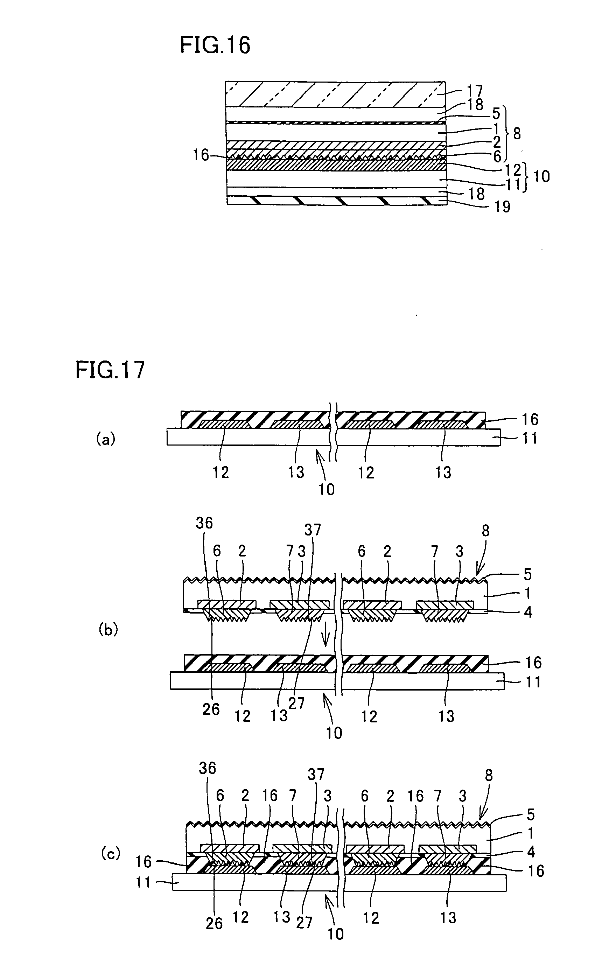

Fig. 15 shows a schematic cross sectional view of still another example of the solar cell module according to the present invention. Fig. 16 also shows a schematic enlarged cross sectional view of the solar cell module shown in Fig. 15 taken along the XVI-XVI direction (the extension direction of each of first conductivity type electrode 6 of back electrode type solar cell 8 and first conductivity type wire 12 of connecting sheet 10: the direction extending on the front surface side and/or the back surface side of the plane of Fig. 15). Furthermore, for the sake of explanation, the concavo-convex structure on the light receiving surface of semiconductor substrate 1 is not shown as a concavo-convex shape also in Fig. 16.

The solar cell module of the present embodiment is **characterized in that**, for example, as shown in Figs. 15 and 16, the surface of first conductivity type electrode 6 of back electrode type solar cell 8 is provided with concave portion 26 and convex portion 36 along the extension direction of first conductivity type electrode 6 and also along the direction orthogonal to the extension direction, and concave portion 26 of the surface of first conductivity type electrode 6 is formed as a resin flowing portion for causing flow of insulating resin 16 pushed away by convex portion 36 of first conductivity type electrode 6.

Furthermore, in the solar cell module of the present embodiment, for example, as shown in Figs. 15 and 16, the surface of second conductivity type electrode 7 of back electrode type solar cell 8 is also provided with concave portion 27 and convex portion 37 along the extension direction of second conductivity type electrode 7 and also along the direction orthogonal to the extension direction, and concave portion 27 of the surface of second conductivity type electrode 7 is also formed as a resin flowing portion for causing insulating resin 16 to flow.

In other words, also in the third embodiment, first conductivity type electrode 6 and second conductivity type electrode 7 of back electrode type solar cell 8 each are shaped to push away insulating resin 16 to establish electrical connection to the wire of connecting sheet 10, and also each have a resin flowing portion for causing flow of insulating resin 16 that is pushed away.

In the third embodiment, in first conductivity type electrode 6 and second conductivity type electrode 7 of back electrode type solar cell 8, concave portions 26 and 27 are provided, respectively, through which insulating resin 16 can flow in the uncured liquid material state. These concave portions 26 and 27 each are formed as a resin flowing portion that is configured to have a shape through which uncured insulating resin 16 can flow that is disposed between the electrode and the wire when convex portion 36 of first conductivity type electrode 6 and convex portion 37 of second conductivity type electrode 7 are brought into contact with first conductivity type wire 12 and second conductivity type wire 13, respectively, of connecting sheet 10. In addition, this resin flowing portion also causes uncured insulating resin 16 to flow therethrough.

In this case, it is preferable that concave portion 26 of first conductivity type electrode 6 is formed between the plurality of convex portions 36 so as to be contiguous to the end of first conductivity type electrode 6. Furthermore, it is preferable that concave portion 26 of second conductivity type electrode 7 is formed between the plurality of convex portions 36 so as to be contiguous to the end of second conductivity type electrode 7. In the case where concave portion 26 of first conductivity type electrode 6 is located contiguous to the end of first conductivity type electrode 6, it is more likely that insulating resin 16 pushed away by convex portion 36 of first conductivity type electrode 6 and then flowing into concave portion 26 of first conductivity type electrode 6 can be discharged from the end of first conductivity type electrode 6 to the outside of first conductivity type electrode 6. Furthermore, in the case where concave portion 26 of second conductivity type electrode 7 is located contiguous to the end of second conductivity type electrode 7, it is more likely that insulating resin 16 pushed away by convex portion 36 of second conductivity type electrode 7 and then flowing into concave portion 26 of second conductivity type electrode 7 can be discharged from the end of second conductivity type electrode 7 to the outside of second conductivity type electrode 7. It is to be noted that the end of first conductivity type electrode 6 may be, for example, the end in the extension direction of conductivity type electrode 6 and/or the end in the direction orthogonal to the extension direction of first conductivity type electrode 6 while the end of second conductivity type electrode 7 may be, for example, the end in the extension direction of second conductivity type electrode 7 and/or the end in the direction orthogonal to the extension direction of second conductivity type electrode 7.

In this case, first conductivity type electrode 6 and second conductivity type electrode 7 of back electrode type solar cell 8 each having a resin flowing portion that is shaped as shown in Figs. 15 and 16 can be formed, for example, by the screen printing method, the vacuum deposition method, the plating method or the like.

For example, in the case where first conductivity type electrode 6 and second conductivity type electrode 7 are formed by the screen printing method, the line shape and the thickness of the meshed metal wire used for a screen are selected, so that fine concavo-convex patterns can be formed on the metal paste surface extruded in the shape of the opening corresponding to the electrode pattern. In this case, the metal wire portion is formed as a concave portion while the opening between the metal wires is formed as a convex portion. Then, the metal paste is dried, for example, at a temperature of approximately 50 °C to 200 °C, and then baked at a temperature of approximately 300 °C to 800 °C. Consequently, first conductivity type electrode 6 and second conductivity type electrode 7 can be formed.

In the case where first conductivity type electrode 6 and second conductivity type electrode 7 are formed by the vacuum deposition method, after metal is subjected to vacuum deposition using a metal mask having an opening corresponding to an electrode pattern, the surface of the metal is roughened by wet etching using a pattern mask such as an insulating film, a resist and the like or by dry etching such as plasma ion processing, sandblasting and the like. Consequently, first conductivity type electrode 6 and second conductivity type electrode 7 can be formed.

Furthermore, in the case where first conductivity type electrode 6 and second conductivity type electrode 7 are formed by the plating method, after a plated layer is formed in the same manner as in the second embodiment, the surface of the metal is roughened by wet etching using a pattern mask such as an insulating film, resist and the like or by dry etching such as plasma ion processing, sandblasting and the like. Consequently, first conductivity type electrode 6 and second conductivity type electrode 7 can be formed.

Furthermore, in order to suitably push away insulating resin 16 to improve the stability of the connection between the electrode of back electrode type solar cell 8 and the wire of connecting sheet 10, it is preferable that first conductivity type electrode 6 and second conductivity type electrode 7 each have a thickness of 10 nm or more and 1000 µm or less.

An example of the method of manufacturing a solar cell with a connecting sheet used in the solar cell module shown in Figs. 15 and 16 will be hereinafter described with reference to the schematic enlarged cross sectional view shown in each of Figs. 17(a) to 17(c).

First, as shown in Fig. 17(a), insulating resin 16 is applied on the surface of connecting sheet 10. In this case, insulating resin 16 will be applied also on the surface of each of first conductivity type wire 12 and second conductivity type wire 13 in connecting sheet 10. In the case where insulating resin 16 is applied on the surface of connecting sheet 10, insulating resin 16 can be applied, for example, on the surface of connecting sheet 10 including the surface of first conductivity type wire 12 and/or the surface of second conductivity type wire 13 in connecting sheet 10. It is to be noted that insulating resin 16 may be applied on the surface of back electrode type solar cell 8. In the case where insulating resin 16 is applied on the surface of back electrode type solar cell 8, insulating resin 16 can be applied, for example, on the surface of back electrode type solar cell 8 including the surface of first conductivity type electrode 6 and/or the surface of second conductivity type electrode 7 in back electrode type solar cell 8.

Then, as shown in Fig. 17(b), back electrode type solar cell 8 is placed on connecting sheet 10.

In this case, as shown in Fig. 17(c), back electrode type solar cell 8 is disposed on connecting sheet 10 such that first conductivity type electrode 6 of back electrode type solar cell 8 is placed on first conductivity type wire 12 of connecting sheet 10. Although not shown, second conductivity type electrode 7 of back electrode type solar cell 8 will be placed on second conductivity type wire 13 of connecting sheet 10. This causes back electrode type solar cell 8 and connecting sheet 10 to be connected to each other.

In this case, convex portion 36 of first conductivity type electrode 6 and convex portion 37 of second conductivity type electrode 7 in back electrode type solar cell 8 each push away insulating resin 16 on connecting sheet 10. Insulating resin 16 pushed away by these convex portions of the electrodes will be placed within each of concave portion 26 of first conductivity type electrode 6 and concave portion 27 of second conductivity type electrode 7 which each serve as a resin flowing portion. In other words, uncured insulating resin 16 in the liquid material state flows between first conductivity type electrode 6 and first conductivity type wire 12 and between second conductivity type electrode 7 and second conductivity type wire 13, which causes convex portion 36 of first conductivity type electrode 6 to be brought into contact with first conductivity type wire 12 and also causes convex portion 37 of second conductivity type electrode 7 to be brought into contact with second conductivity type wire 13. When insulating resin 16 which flows in this case is placed and cured within the resin flowing portion (concave portion 26 of first conductivity type electrode 6 and concave portion 27 of second conductivity type electrode 7), this insulating resin 16 joins first conductivity type electrode 6 and first conductivity type wire 12 together and also joins second conductivity type electrode 7 and second conductivity type wire 13 together in the resin flowing portion.

Accordingly, convex portion 36 of first conductivity type electrode 6 is brought into contact with first conductivity type wire 12 to thereby ensure electrical connection while convex portion 37 of second conductivity type electrode 7 is also brought into contact with second conductivity type wire 13 of connecting sheet 10 to thereby ensure electrical connection.

In the state where insulating resin 16 is cured, first conductivity type electrode 6 and second conductivity type electrode 7 in back electrode type solar cell 8 and first conductivity type wire 12 and second conductivity type wire 13 in connecting sheet 10 are respectively partially joined together in the resin flowing portion by insulating resin 16, and also brought into contact with each other at the top portion of the convex portion other than the resin flowing portion, thereby establishing electrical connection therebetween.

Therefore, in the case where back electrode type solar cell 8 having the above-described configuration is used, it becomes possible to suppress the problem that insulating resin 16 is sandwiched between the electrode of back electrode type solar cell 8 and the wire of connecting sheet 10, which prevents electrical connection between the electrode of back electrode type solar cell 8 and the wire of connecting sheet 10. Therefore, the characteristics of the solar cell with a connecting sheet and the solar cell module can be improved.

Furthermore, since insulating resin 16 is filled in the resin flowing portion of the electrode of back electrode type solar cell 8 to cover and protect the periphery of the electrode, the long-term reliability of the solar cell with a connecting sheet and the solar cell module can also be enhanced.

In the above-described configuration, first conductivity type electrode 6 and second conductivity type electrode 7 of back electrode type solar cell 8 each are provided with the resin flowing portion. In the present invention, however, at least one of first conductivity type electrode 6 and second conductivity type electrode 7 only needs to be provided with the resin flowing portion.

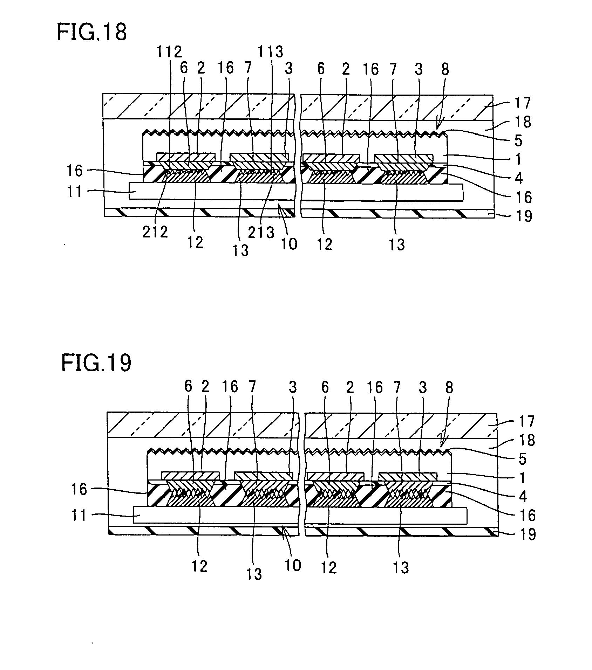

Furthermore, in the above-described configuration, concave portion 26 of first conductivity type electrode 6 and concave portion 27 of second conductivity type electrode 7 in back electrode type solar cell 8 each are formed as a resin flowing portion. In the present invention, for example, as shown in the schematic enlarged cross sectional view in Fig. 18, concave portion 112 and convex portion 212 may be provided on the surface of first conductivity type wire 12 of connecting sheet 10 along the extension direction of first conductivity type wire 12 and the direction orthogonal to the extension direction, while a concave portion 113 and a convex portion 213 may be provided on the surface of second conductivity type wire 13 along the extension direction of second conductivity type wire 13 and the direction orthogonal to the extension direction. In this case, concave portion 112 in first conductivity type wire 12 and concave portion 113 in second conductivity type wire 13 each serve as a resin flowing portion.

It is preferable that concave portion 112 of first conductivity type wire 12 is formed between the plurality of convex portions 212 so as to be contiguous to the end of first conductivity type wire 12. Furthermore, it is preferable that concave portion 112 of second conductivity type wire 13 is formed between the plurality of convex portions 212 so as to be contiguous to the end of second conductivity type wire 13. In the case where concave portion 112 of first conductivity type wire 12 is located contiguous to the end of first conductivity type wire 12, it is more likely that insulating resin 16 pushed away by convex portion 212 of first conductivity type wire 12 and then flowing into concave portion 112 of first conductivity type wire 12 can be discharged from the end of first conductivity type wire 12 to the outside of first conductivity type wire 12. Furthermore, in the case where concave portion 112 of second conductivity type wire 13 is located contiguous to the end of second conductivity type wire 13, it is more likely that insulating resin 16 pushed away by convex portion 212 of second conductivity type wire 13 and then flowing into concave portion 112 of second conductivity type wire 13 can be discharged from the end of second conductivity type wire 13 to the outside of second conductivity type wire 13. It is to be noted that the end of first conductivity type wire 12 may be, for example, the end in the extension direction of first conductivity type wire 12 and/or the end in the direction orthogonal to the extension direction of first conductivity type wire 12, while the end of second conductivity type wire 13 may be, for example, the end in the extension direction of second conductivity type wire 13 and/or the end in the direction orthogonal to the extension direction of second conductivity type wire 13.

In this case, although first conductivity type wire 12 having concave portion 112 and convex portion 212 and second conductivity type wire 13 having concave portion 113 and convex portion 213 can also be formed, for example, by the above-mentioned screen printing method, the vacuum deposition method, the plating method or the like, these wires can also be formed by etching a metal foil.

In the case where first conductivity type wire 12 and second conductivity type wire 13 of connecting sheet 10 are formed by etching a metal foil, for example, the metal foil formed by rolling, the electrolytic plating method and the like are first formed on the surface of insulating base material 11. Then, after a resist is patterned on the surface of the metal foil so as to provide a main opening and a sub opening, the metal foil is etched by acid or the like, to pattern the metal foil in the pattern of each of first conductivity type wire 12 and second conductivity type wire 13. Consequently, first conductivity type wire 12 and second conductivity type wire 13 each made of the patterned metal foil are formed. The surface of the metal is then roughened by wet etching using a pattern mask such as an insulating film, resist and the like or by dry etching such as plasma ion processing, sandblasting and the like. Consequently, first conductivity type wire 12 and second conductivity type wire 13 can be formed.

Furthermore, in the configuration shown in Fig. 18, the resin flowing portion is provided in each of first conductivity type wire 12 and second conductivity type wire 13 of connecting sheet 10. In the present invention, however, the resin flowing portion only needs to be provided in at least one of first conductivity type wire 12 and second conductivity type wire 13. Furthermore, in order to suitably push away insulating resin 16 to improve the stability of the connection between the electrode of back electrode type solar cell 8 and the wire of connecting sheet 10, it is preferable that first conductivity type wire 12 and second conductivity type wire 13 each have a thickness of 10 nm or more and 1000 µm or less.

Furthermore, in the present invention, for example, as shown in the schematic enlarged cross sectional view in Fig. 19, a resin flowing portion (concave portion) may be provided in each of first conductivity type electrode 6 and second conductivity type electrode 7 of back electrode type solar cell 8, while a resin flowing portion (concave portion) may also be provided in each of first conductivity type wire 12 and second conductivity type wire 13 on the surface of insulating base material 11 of connecting sheet 10. Also in the configuration shown in Fig. 19, it is preferable that the thickness of each of first conductivity type electrode 6, second conductivity type electrode 7, first conductivity type wire 12, and second conductivity type wire 13 for suitably pushing away insulating resin 16 to improve the stability of the connection between the electrode of back electrode type solar cell 8 and the wire of connecting sheet 10 is 10 nm or more and 1000 µm or less as in the above-described configuration.

In this case, it is preferable the concave portion of first conductivity type electrode 6 is formed between the plurality of convex portions 36 so as to be contiguous to the end of first conductivity type electrode 6. Furthermore, it is preferable that the concave portion of second conductivity type electrode 7 is formed between the plurality of convex portions so as to be contiguous to the end of second conductivity type electrode 7. In the case where the concave portion of first conductivity type electrode 6 is located contiguous to the end of first conductivity type electrode 6, it is more likely that insulating resin 16 pushed away by the convex portion of first conductivity type electrode 6 and then flowing into the concave portion of first conductivity type electrode 6 can be discharged from the end of first conductivity type electrode 6 to the outside of first conductivity type electrode 6. In the case where the concave portion of second conductivity type electrode 7 is located contiguous to the end of second conductivity type electrode 7, it is more likely that insulating resin 16 pushed away by the convex portion of second conductivity type electrode 7 and then flowing into the concave portion of second conductivity type electrode 7 can be discharged from the end of second conductivity type electrode 7 to the outside of second conductivity type electrode 7. It is to be noted that the end of first conductivity type electrode 6 may be, for example, the end in the extension direction of first conductivity type electrode 6 and/or the end in the direction orthogonal to the extension direction of first conductivity type electrode 6, while the end of second conductivity type electrode 7 may be, for example, the end in the extension direction of second conductivity type electrode 7 and/or the end in the direction orthogonal to the extension direction of second conductivity type electrode 7.

It is preferable that the concave portion of first conductivity type wire 12 is formed between the plurality of convex portions so as to be contiguous to the end of first conductivity type wire 12. Furthermore, it is preferable that the concave portion of second conductivity type wire 13 is formed between the plurality of convex portions so as to be contiguous to the end of second conductivity type wire 13. In the case where the concave portion of first conductivity type wire 12 is located contiguous to the end of first conductivity type wire 12, it is more likely that insulating resin 16 pushed away by the convex portion of first conductivity type wire 12 and then flowing into the concave portion of first conductivity type wire 12 can be discharged from the end of first conductivity type wire 12 to the outside of first conductivity type wire 12. Furthermore, in the case where the concave portion of second conductivity type wire 13 is located contiguous to the end of second conductivity type wire 13, it is more likely that insulating resin 16 pushed away by the convex portion of second conductivity type wire 13 and then flowing into the concave portion of second conductivity type wire 13 can be discharged from the end of second conductivity type wire 13 to the outside of second conductivity type wire 13. It is to be noted that the end of first conductivity type wire 12 may be, for example, the end in the extension direction of first conductivity type wire 12 and/or the end in the direction orthogonal to the extension direction of first conductivity type wire 12, while the end of second conductivity type wire 13 may be, for example, the end in the extension direction of second conductivity type wire 13 and/or the end in the direction orthogonal to the extension direction of second conductivity type wire 13.

Description other than the above in the present embodiment is the same as that in each of the first and the second embodiments, and therefore, will not be repeated.

### EXAMPLES

### [Examples]

In the example, a solar cell module having the configuration as shown in Fig. 1 was produced. The method of manufacturing a solar cell module of the example will be hereinafter described.

First prepared as semiconductor substrate 1 was an n-type silicon substrate having a thickness of 200 µm and having a light receiving surface and a back surface that each had a quasi-square shape having each side of 126 mm. Then, on the back surface of the n-type silicon substrate, an n-type impurity doping region having a strip shape was formed as first conductivity type impurity diffusion region 2 and a p-type impurity doping region having a strip shape was formed as second conductivity type impurity diffusion region 3, which were alternately arranged.

Then, a silicon nitride film was formed as passivation film 4 by the plasma CVD method on the entire back surface of the n-type silicon substrate. Then, after a concavo-convex structure such as a textured structure was formed on the entire light receiving surface of the n-type silicon substrate, a silicon nitride film was formed as an antireflection film 5 on the concavo-convex structure by the plasma CVD method.

Then, after a contact hole was formed by removing a part of the silicon nitride films on the back surface of the n-type silicon substrate, a silver electrode extending in the strip shape as first conductivity type electrode 6 and having an outer surface that is curved like a side surface of a circular cylinder was formed on the n-type impurity doping region exposed from the contact hole. Also, a silver electrode extending in the strip shape as second conductivity type electrode 7 and having an outer surface that is curved like a side surface of a circular cylinder was formed on the p-type impurity doping region exposed from the contact hole. In this case, the thickness of each of the silver electrodes was within the range of 10 µm to 15 µm while the pitch between the adjacent silver electrodes was set at 0.75 mm pitch.

Furthermore, the silver electrodes as first conductivity type electrode 6 and second conductivity type electrode 7 were formed as in the following manner. First, a screen made using the emulsion and formed so as to have an opening patterned in accordance with the electrode pattern was used to gradually extrude the silver paste by the pressure applied from the screen through the opening of the screen toward the n-type impurity doping region or the p-type impurity doping region on the back surface of the n-type silicon substrate. Then, the extruded silver paste was dried at a temperature of approximately 100 °C and then baked at a temperature of approximately 600 °C. In this way, the back electrode type solar cell in the example was produced.

Furthermore, as shown in Fig. 6, prepared as connecting sheet 10 was a connecting sheet having the configuration in which copper wires patterned as shown in Fig. 6 were formed each as first conductivity type wire 12 and second conductivity type wire 13 on the surface of the polyimide film as insulating base material 11. The copper wires of this connecting sheet each were configured to have a pattern allowing 16 sheets of back electrode type solar cells produced as described above to be electrically connected in series.

Then, as shown in Figs. 7(a) to 7(c), after applying a thermosetting resin as insulating resin 16 on the surface of the connecting sheet produced as described above, the back electrode type solar cell produced as described above was placed. Then, the thermosetting resin was heated and cured to thereby connect the back electrode type solar cell and the connecting sheet to each other, thereby producing a solar cell with a connecting sheet. In this case, the back electrode type solar cell was placed on the connecting sheet in accordance with the alignment mark formed in advance in the back electrode type solar cell.

Then, as shown in Fig. 1, the back electrode type solar cell produced as described above was sealed by vacuum pressure bonding within the ethylene vinyl acetate resin as sealing material 18 between the glass substrate as transparent substrate 17 and the film as back film 19 having a configuration in which both surfaces of the aluminum foil are sandwiched between the PET films. In this case, vacuum pressure bonding was performed by conducting vacuum evacuation kept at 130 °C for 5 minutes. The vacuum pressure bonding was followed by heating at 145 °C for 40 minutes, to thereby cause thermal curing of the ethylene vinyl acetate resin. Thus, the solar cell module of the example having the configuration shown in Fig. 1 was completed.

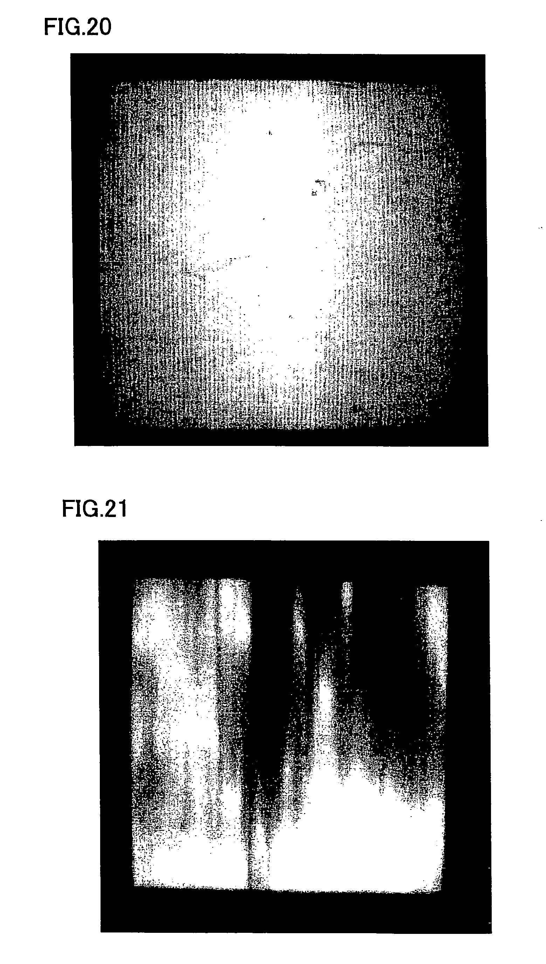

Fig. 20 shows an EL luminescence image of the solar cell module in the example. As shown in Fig. 20, the solar cell module of the example shows not so many black portions indicating connection failure between the electrode of the back electrode type solar cell and the wire of the connecting sheet, but shows almost uniform luminescence in the plane. Thus, it was confirmed that connection between the electrode of the back electrode type solar cell and the wire of the connecting sheet was excellent.

### [Comparative Example]

In the comparative example, a solar cell module of the comparative example having a configuration shown in Fig. 7(c) was produced in the manner similar to that in the example, except that an n-type silicon substrate was used which had a light receiving surface and a back surface that each had a quasi-square shape having each side of 90 mm, the pitch between silver electrodes was set at 0.6 mm, and the electrode of the back electrode type solar cell and the wire of the connecting sheet each were configured to have a planar surface.

Fig. 21 shows an EL luminescence image of the solar cell module of the comparative example. As shown in Fig. 21, in the solar cell module of the comparative example, black portions indicating connection failure between the electrode of the back electrode type solar cell and the wire of the connecting sheet were confirmed in the large area in the plane. Thus, it was confirmed that the electrode of the back electrode type solar cell and the wire of the connecting sheet was not so favorably connected to each other as compared with the solar cell module of the example.

It should be understood that the embodiments and examples disclosed herein are illustrative and non-restrictive in every respect. The scope of the present invention is defined by the terms of the claims, rather than the description above, and is intended to include any modifications within the scope and meaning equivalent to the terms of the claims.

### INDUSTRIAL APPLICABILITY

The present invention can be applied to a back electrode type solar cell, a connecting sheet, a solar cell with a connecting sheet, a solar cell module, a method of manufacturing the solar cell with a connecting sheet, and a method of manufacturing the solar cell module.

### REFERENCE SIGNS LIST

1 semiconductor substrate, 1a slice damage, 2 first conductivity type impurity diffusion region, 3 second conductivity type impurity diffusion region, 4 passivation film, 4a, 4b contact hole, 5 antireflection film, 6 first conductivity type electrode, 7 second conductivity type electrode, 8, 80 back electrode type solar cell, 10, 100 connecting sheet, 11 insulating base material, 12, 12a first conductivity type wire, 13, 13a second conductivity type wire, 14 connecting wire, 16 insulating resin, 17 transparent substrate, 18 sealing material, 19 back film, 26, 27, 112, 113 concave portion, 36, 37, 212, 213 convex portion, 41 conductive layer, 42 resist, 60 first conductivity type collector electrode, 70 second conductivity type collector electrode.

## Claims

1. A back electrode type solar cell (8) comprising:
a semiconductor substrate (1) in which a first conductivity type impurity diffusion region (2) and a second conductivity type impurity diffusion region (3) are formed; and
a first conductivity type electrode (6) and a second conductivity type electrode (7) formed on one of surfaces of said semiconductor substrate (1) and corresponding to said first conductivity type impurity diffusion region (2) and said second conductivity type impurity diffusion region (3), respectively,
at least one of said first conductivity type electrode (6) and said second conductivity type electrode (7) protruding in a direction opposite to said semiconductor substrate (1) so as to have a width continuously reduced in accordance with an increase in a distance from said semiconductor substrate (1).

2. A solar cell with a connecting sheet, comprising:
the back electrode type solar cell (8) according to claim 1; and
a connecting sheet (10) having an insulating base material (11), and a first conductivity type wire (12) and a second conductivity type wire (13) disposed on said insulating base material (11), wherein
said back electrode type solar cell (8) is disposed on said connecting sheet (10) such that said first conductivity type electrode (6) of said back electrode type solar cell (8) is in contact with said first conductivity type wire (12) of said connecting sheet (10) and said second conductivity type electrode (7) of said back electrode type solar cell (8) is in contact with said second conductivity type wire (13) of said connecting sheet (10), and
an insulating resin (16) joins at least a part of a region between said back electrode type solar cell (8) and said connecting sheet (10) excluding a region in which said first conductivity type electrode (6) of said back electrode type solar cell (8) is in contact with said first conductivity type wire (12) of said connecting sheet (10) to establish electrical connection therebetween, and a region in which said second conductivity type electrode (7) of said back electrode type solar cell (8) is in contact with said second conductivity type wire (13) of said connecting sheet (10) to establish electrical connection therebetween.

3. A solar cell module, the solar cell with a connecting sheet according to claim 2 being sealed by a sealing material on a transparent substrate.

4. A back electrode type solar cell (8) comprising:
a semiconductor substrate (1) in which a first conductivity type impurity diffusion region (2) and a second conductivity type impurity diffusion region (3) are formed; and
a first conductivity type electrode (6) and a second conductivity type electrode (7) formed on one of surfaces of said semiconductor substrate (1) and corresponding to said first conductivity type impurity diffusion region (2) and said second conductivity type impurity diffusion region (3), respectively, wherein
at least one of said first conductivity type electrode (6) and said second conductivity type electrode (7) has a surface provided with a plurality of convex portions and a concave portion formed between said convex portions and located contiguous to an end.

5. A solar cell with a connecting sheet, comprising:
the back electrode type solar cell (8) according to claim 4; and
a connecting sheet (10) having an insulating base material (11), and a first conductivity type wire (12) and a second conductivity type wire (13) disposed on said insulating base material (11), wherein
said back electrode type solar cell (8) is disposed on said connecting sheet (10) such that said first conductivity type electrode (6) of said back electrode type solar cell (8) is in contact with said first conductivity type wire (12) of said connecting sheet (10) and said second conductivity type electrode (7) of said back electrode type solar cell (8) is in contact with said second conductivity type wire (13) of said connecting sheet (10), and
an insulating resin (16) joins at least a part of a region between said back electrode type solar cell (8) and said connecting sheet (10) excluding a region in which said first conductivity type electrode (6) of said back electrode type solar cell (8) is in contact with said first conductivity type wire (12) of said connecting sheet (10) to establish electrical connection therebetween and a region in which said second conductivity type electrode (7) of said back electrode type solar cell (8) is in contact with said second conductivity type wire (13) of said connecting sheet (10) to establish electrical connection therebetween.

6. A solar cell module, the solar cell with a connecting sheet according to claim 5 being sealed by a sealing material on a transparent substrate.

7. A connecting sheet (10) comprising:
an insulating base material (11); and
a first conductivity type wire (12) and a second conductivity type wire (13) disposed on said insulating base material (11) in order to connect an electrode (6, 7) of a back electrode type solar cell (8), wherein
at least one of said first conductivity type wire (12) and said second conductivity type wire (13) protrudes in a direction opposite to said insulating base material (11) so as to have a width continuously reduced in accordance with an increase in a distance from said insulating base material (11).

8. A solar cell with a connecting sheet, comprising:
the connecting sheet (10) according to claim 7; and
a back electrode type solar cell (8) having a first conductivity type electrode (6) and a second conductivity type electrode (7) formed on one of surfaces of a semiconductor substrate (1) having a first conductivity type impurity diffusion region (2) and a second conductivity type impurity diffusion region (3) formed therein, said first conductivity type electrode (6) and said second conductivity type electrode (7) corresponding to said first conductivity type impurity diffusion region (2) and said second conductivity type impurity diffusion region (3), respectively, wherein
said back electrode type solar cell (8) is disposed on said connecting sheet (10) such that said first conductivity type electrode (6) of said back electrode type solar cell (8) is in contact with said first conductivity type wire (12) of said connecting sheet (10) and said second conductivity type electrode (7) of said back electrode type solar cell (8) is in contact with said second conductivity type wire (13) of said connecting sheet (10), and
an insulating resin (16) joins at least a part of a region between said back electrode type solar cell (8) and said connecting sheet (10) excluding a region in which said first conductivity type electrode (6) of said back electrode type solar cell (8) is in contact with said first conductivity type wire (12) of said connecting sheet (10) to establish electrical connection therebetween, and a region in which said second conductivity type electrode (7) of said back electrode type solar cell (8) is in contact with said second conductivity type wire (13) of said connecting sheet (10) to establish electrical connection therebetween.

9. A solar cell module, the solar cell with a connecting sheet according to claim 8 being sealed by a sealing material on a transparent substrate.

10. A connecting sheet (10) comprising:
an insulating base material (11); and
a first conductivity type wire (12) and a second conductivity type wire (13) disposed on said insulating base material (11) in order to connect an electrode (6, 7) of a back electrode type solar cell (8), wherein
at least one of said first conductivity type wire (12) and said second conductivity type wire (13) has a surface provided with a plurality of convex portions and a concave portion formed between said convex portions and located contiguous to an end.

11. A solar cell with a connecting sheet, comprising:
the connecting sheet (10) according to claim 10; and
a back electrode type solar cell (8) having a first conductivity type electrode (6) and a second conductivity type electrode (7) formed on one of surfaces of a semiconductor substrate (1) having a first conductivity type impurity diffusion region (2) and a second conductivity type impurity diffusion region (3) formed therein, said first conductivity type electrode (6) and said second conductivity type electrode (7) corresponding to said first conductivity type impurity diffusion region (2) and said second conductivity type impurity diffusion region (3), respectively, wherein
said back electrode type solar cell (8) is disposed on said connecting sheet (10) such that said first conductivity type electrode (6) of said back electrode type solar cell (8) is in contact with said first conductivity type wire (12) of said connecting sheet (10) and said second conductivity type electrode (7) of said back electrode type solar cell (8) is in contact with said second conductivity type wire (13) of said connecting sheet (10), and
an insulating resin (16) joins at least a part of a region between said back electrode type solar cell (8) and said connecting sheet (10) excluding a region in which said first conductivity type electrode (6) of said back electrode type solar cell (8) is in contact with said first conductivity type wire (12) of said connecting sheet (10) to establish electrical connection therebetween, and a region in which said second conductivity type electrode (7) of said back electrode type solar cell (8) is in contact with said second conductivity type wire (13) of said connecting sheet (10) to establish electrical connection therebetween.

12. A solar cell module, the solar cell with a connecting sheet according to claim 11 being sealed by a sealing material on a transparent substrate.

13. A method of manufacturing a solar cell with a connecting sheet, said solar cell with a connecting sheet including
a back electrode type solar cell (8) having a first conductivity type electrode (6) and a second conductivity type electrode (7) formed on one of surfaces of a semiconductor substrate (1) having a first conductivity type impurity diffusion region (2) and a second conductivity type impurity diffusion region (3) formed therein, said first conductivity type electrode (6) and said second conductivity type electrode (7) corresponding to said first conductivity type impurity diffusion region (2) and said second conductivity type impurity diffusion region (3), respectively, and
a connecting sheet (10) having an insulating base material (11), and a first conductivity type wire (12) and a second conductivity type wire (13) disposed on said insulating base material (11), said method comprising the steps of:
applying an insulating resin (16) on a surface of said connecting sheet (10) including a surface of said first conductivity type wire (12) and/or a surface of said second conductivity type wire (13); and
placing said back electrode type solar cell (8) on said connecting sheet (10).

14. A method of manufacturing a solar cell module, comprising the step of sealing the solar cell with a connecting sheet manufactured by the method of manufacturing the solar cell with a connecting sheet according to claim 13 on a transparent substrate by a sealing material.

15. A method of manufacturing a solar cell with a connecting sheet, said solar cell with a connecting sheet including
a back electrode type solar cell (8) having a first conductivity type electrode (6) and a second conductivity type electrode (7) formed on one of surfaces of a semiconductor substrate (1) having a first conductivity type impurity diffusion region (2) and a second conductivity type impurity diffusion region (3) formed therein, said first conductivity type electrode (6) and said second conductivity type electrode (7) corresponding to said first conductivity type impurity diffusion region (2) and said second conductivity type impurity diffusion region (3), respectively, and
a connecting sheet (10) having an insulating base material (11), and a first conductivity type wire (12) and a second conductivity type wire (13) disposed on said insulating base material (11), said method comprising the steps of:
applying an insulating resin (16) on a surface of said back electrode type solar cell (8) including a surface of said first conductivity type wire (6) and/or a surface of said second conductivity type wire (7); and
placing said back electrode type solar cell (8) on said connecting sheet (10).

16. A method of manufacturing a solar cell module, comprising the step of sealing the solar cell with a connecting sheet manufactured by the method of manufacturing the solar cell with a connecting sheet according to claim 15 on a transparent substrate by a sealing material.
